(19)

Europäisches Patentamt
European Patent Office
Office européen des brevets

(11)     **EP 3 042 972 B1**

(12)                                 **EUROPEAN PATENT SPECIFICATION**

(45) Date of publication and mention
of the grant of the patent:
**02.01.2019 Bulletin 2019/01**

(51) Int Cl.:
*C22C 9/00* *(2006.01)*          *C22F 1/08* *(2006.01)*
*H01B 1/02* *(2006.01)*          *H01B 5/02* *(2006.01)*
*H01B 13/00* *(2006.01)*

(21) Application number: **14842439.3**

(22) Date of filing: **05.09.2014**

(86) International application number:
**PCT/JP2014/073589**

(87) International publication number:
**WO 2015/034071 (12.03.2015 Gazette 2015/10)**

(54) **COPPER ALLOY WIRE**

DRAHT AUS KUPFERLEGIERUNG

FIL D'ALLIAGE DE CUIVRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **06.09.2013 JP 2013185542**

(43) Date of publication of application:
**13.07.2016 Bulletin 2016/28**

(73) Proprietor: **Furukawa Electric Co., Ltd.
Chiyoda-ku
Tokyo 100-8322 (JP)**

(72) Inventor: **TAKAZAWA, Tsukasa
Tokyo 100-8322 (JP)**

(74) Representative: **Forstmeyer, Dietmar et al
BOETERS & LIECK
Oberanger 32
80331 München (DE)**

(56) References cited:
**EP-A1- 2 610 359          EP-A1- 3 128 019
WO-A1-2011/068124          WO-A1-2011/068126
WO-A1-2012/029717          WO-A1-2013/031841
CN-A- 1 811 998          CN-A- 102 851 527
JP-A- 2014 047 401          JP-B2- 4 932 974**

EP 3 042 972 B1

## Description

TECHNICAL FIELD

The present invention relates to a copper alloy wire, and more specifically the present invention relates to an extra-fine copper alloy wire for magnet wires.

BACKGROUND ART

Along with the development in electronic equipment, making the size of an electronic part smaller is in progress, and there is an increasing demand for extra-fine copper alloy wire (round wire) having a wire diameter of 0.1 mm or less. For example, a coil for micro speakers that is used in mobile phones, smart phones, and the like, is produced by working an extra-fine wire (a magnet wire) having a wire diameter of 0.1 mm or less by winding into a coil shape.

For this winding, toughness (elongation) is required as the workability capable of turn formation, and pure copper excellent in toughness has been conventionally used. However, pure copper is excellent in electrical conductivity but has low physical strength. In addition, there is a problem that pure copper is low in resistance to fatigue that is accompanied with coil vibration, and thus the service life of a coil is short. Furthermore, there is a demand for further enhancement of coil formability in which coil-winding can be performed from a lengthy copper alloy wire.

In order to solve these problems, there is a proposal of a technique of using a high-concentration Cu-Ag alloy containing 2 to 15 mass% of Ag that can enhance the tensile strength almost without lowering the electrical conductivity, to achieve a balance between the elongation and the physical strength by defining the working degree of the final working (Patent Literature 1). Furthermore, in general, a metal or an alloy, which has been subjected to working, is enhanced in tensile strength and lowered in elongation. However, when this is subjected to heating at a certain temperature or higher, elongation is recovered again, while physical strength is lowered. Thus, there is a proposal of a technique of achieving a balance between physical strength and elongation even in a low-concentration alloy, by carrying out the heating at a temperature lower than or equal to the softening temperature (Patent Literature 2). However, this method is difficult to control the heating temperature and time period. In this regard, there is a proposal of a technique of performing a semi-softening treatment of achieving a balance between physical strength and elongation, by adding 0.05 to 0.2 mass% of Ag and 0.003 to 0.01 mass% of Zr into copper to widen the softening temperature range (Patent Literature 3).

CITATION LIST

PATENT LITERATURES

Patent Literature 1: JP-A-2009-280860 ("JP-A" means unexamined published Japanese patent application)
Patent Literature 2: Japanese Patent No. 3941304
Patent Literature 3: JP-B-H04(1992)-77060 ("JP-B" means examined Japanese patent publication)

CN 102851527 A discloses a high-speed railway copper silver magnesium alloy contact wire consisting of 0.05 -0.15 mass% Ag; 0.20 to 0.40 mass% Mg, not more than 0.1 mass % impurities, with the balance being Cu.

SUMMARY OF INVENTION

TECHNICAL PROBLEM

However, according to the demand for lengthening the service life of magnet wires and the demand for making magnet wires extremely finer (for example, a wire diameter of 0.07 mm or less) as a result of making the size of electronic parts further smaller, in addition to achievement of a balance between further physical strength enhancement of copper alloy wires and enhancement of elongation, enhancement of coil-winding property and further enhancement of resistance to bending fatigue have been demanded. The resistance to bending fatigue is one of criteria for the service life of the coil.

The technique described in Patent Literature 1 relates to an alloy, which contains a high concentration of Ag up to 2 to 15%, and which is a high-cost material. In this regard, there is a demand for a technique by which sufficient physical strength and elongation can be exerted even in the case of a lower-concentration Cu-Ag alloy or a copper alloy not containing Ag. Further, as described in Patent Literature 1, when the Ag content is increased in order to further increase the physical strength, rather, electrical conductivity is lowered. Furthermore, Ag is an element, which enhances heat resistance, and makes it difficult to perform heating. Further, when working is performed until wires become extra-fine wires, characteristics may not be sufficiently exhibited only by defining the degree of the final working in some cases.

It is difficult to achieve further enhancement in physical strength and further enhancement of resistance to bending fatigue, while securing electrical conductivity and elongation, by using a copper alloy described in Patent Literature 2.

Furthermore, the method of performing a semi-softening treatment by adding a trace amount of Zr to a low-concentration Cu-Ag alloy (Patent Literature 3) can easily achieve a balance between elongation and physical strength; however, the method is insufficient in view of strength enhancement.

Furthermore, recently, the shape of magnet wires is not limited to round wires, and investigations have also been conducted on the employment of square wires and rectangular wires. Even in the cases of these square wires and rectangular wires, it is requested to employ a wire with a thickness that is thin to the extent of that corresponding to the wire diameter of the round wire.

The present invention was achieved in view of the problems in those conventional art, and it is an object of the present invention to provide, at low cost, a copper alloy wire that is excellent in a balance between high physical strength and favorable elongation, that is excellent in coil characteristics (service life of the coil and coil formability), which is obtained by using the copper alloy wire, and that is used, for example, in magnet wires.

SOLUTION TO PROBLEM

The inventor of the present invention conducted thorough investigations on various copper alloys, and heating and working conditions therefor, in order to develop a copper alloy wire that is excellent in a balance between high physical strength and favorable elongation, that is excellent in coil characteristics (service life of the coil and coil formability), which is obtained by using the copper alloy wire, and that is used, for example, in magnet wires. As a result, the inventor has found that when the recrystallized texture of the copper alloy wire is controlled, a balance between tensile strength and elongation is achieved at a high level, and thus a copper alloy wire that is also excellent in its coil characteristics (service life of the coil and coil formability) is obtained. The present invention was completed based on those findings.

That is, the present invention provides the following means:

(1) A copper alloy wire consisting of at least one selected from the group consisting of:

[1] 0.1 to 4 mass% of Ag; and
[2] at least one selected from the group consisting of Sn, Mg, Zn, In, Ni, Co, Zr and Cr each at a content of 0.05 to 0.3 mass%,
with the balance being Cu and unavoidable impurities, wherein the copper alloy wire has a recrystallized texture, an area ratio of grains having <100> orientation is 30% or more of the entire measurement area, wherein the area ratio of the grains having <100> orientation is obtained by an EBSD method in such a manner that the transverse cross-section of a copper alloy wire sample is smoothed to be a measurement surface, the orientation of grains on the measurement surface is measured at a step of 0.02 $\mu$m in the entire diameter direction of the copper alloy wire sample after the measurement conditions are adjusted with respect to the copper alloy wire sample such that a vacuum degree is set to about $10^{-4}$ to $10^{-5}$ Pa, and an acceleration voltage is set to 20 to 30 V, and a reliability index, that is, a CI value, as calculated with OIM software is set to 0.2 or more, and then the area ratio of the grain having <100> orientation with respect to the entire measurement area is calculated based on the measurement result; and wherein the copper alloy wire has a tensile strength of 350 MPa or more, a semi-softened state with an elongation of 10% to 30%, and a wire diameter or wire thickness of 0.1 mm or less and 0.01 mm or more.

(2) The copper alloy wire according to (1), wherein the area ratio of the grains having <100> orientation is 50% or more of the entire measurement area.
(3) The copper alloy wire according to (1) or (2), wherein the area ratio of the grains having <100> orientation is less than 75% of the entire measurement area.
(4) The copper alloy wire according to any one of (1) to (3), wherein the average grain size of the matrix is 0.2 $\mu$m or more but 5 $\mu$m or less.
(5) The copper alloy wire according to any one of (1) to (4), wherein when a radius of the transverse cross-section of the wire is represented as r (mm) or a thickness of the wire is represented as t (mm), a region of 0.7r or 0.7t toward the outermost surface of the wire from the center O of the transverse cross-section is designated as a center portion, and a region to the outermost surface of the wire outside the center portion is designated as an outer circumferential portion, an area ratio Io(100) of grains having <100> orientation in the outer circumferential portion to the entire measurement area and an area ratio Ii(100) of grains having <100> orientation in the center portion to the entire measurement area satisfy the relationship represented by Io(100)/Ii(100) > 1.2.

(6) The copper alloy wire according to any one of (1) to (4), wherein when a radius of the transverse cross-section of the wire is represented as r (mm) or a thickness of the wire is represented as t (mm), a region of 0.7r or 0.7t toward the outermost surface of the wire from the center O of the transverse cross-section is designated as a center portion, and a region to the outermost surface of the wire outside the center portion is designated as an outer circumferential portion, an area ratio Io(100) of grains having <100> orientation in the outer circumferential portion to the entire measurement area and an area ratio Ii(100) of grains having <100> orientation in the center portion to the entire measurement area satisfy the relationship represented by Io(100)/Ii(100) < 0.8.

(7) The copper alloy wire according to any one of (1) to (6), wherein the area ratio of grains having <100> orientation is 55% or more of the entire measurement area and the area ratio of grains having <111> orientation is 25% or less of the entire measurement area.

Herein, in the present specification, a semi-softened state means a state in which elongation of the copper alloy wire satisfies 10% to 30%. Also, a semi-softening treatment means a heating that brings about the semi-softened state. Furthermore, the semi-softening temperature range means a range of heating temperature that brings about a state in which elongation of the copper alloy wire after heating satisfies 7% to 30%. In this regard, a softening temperature means a heating temperature that brings about a state in which, in a copper alloy wire after heating, the tensile strength is no longer lowered.

On the other hand, a softened state means a recovered state in which elongation of a copper alloy wire is more than 30%. Furthermore, a softening treatment means a heating at a high temperature that brings about the softened state.

In the present invention, a wire means to include a square wire or a rectangular wire, in addition to a round wire. Thus, unless otherwise specified, the wire of the present invention collectively means a round wire, a square wire, and a rectangular wire. Herein, the size of the wire means, in the case of a round wire (the cross-section in the transverse direction (TD) is circular), the wire diameter $\phi$ (the diameter of the circle of the cross-section) of the round wire; in the case of a square wire (the cross-section in the transverse direction is square), the thickness t and the width w (each being the length of one side of the square of the cross-section and being identical to each other) of the square wire; and in the case of a rectangular wire (the cross-section in the transverse direction is rectangular), the thickness t (the length of a shorter side of the rectangle of the cross-section) and the width w (the length of a longer side of the rectangle of the cross-section) of the rectangular wire.

ADVANTAGEOUS EFFECTS OF INVENTION

According to the present invention, it is possible to obtain a copper alloy wire that is excellent in a balance between high physical strength necessary for a coil and favorable elongation necessary for coil formation and that is also excellent in characteristics of a coil obtained by using the copper alloy wire (specifically, the service life of a coil represented by resistance to bending fatigue and coil formability in which a lenghty copper alloy wire can be formed in the coil with less defects). The copper alloy wire of the present invention can be suitably used, for example, for a magnet wire or the like.

In addition, it is possible to produce the copper alloy wire at low cost stably.

Other and further features and advantages of the invention will appear more fully from the following description, appropriately referring to the accompanying drawings.

BRIEF DESCRIPTION OF DRAWINGS

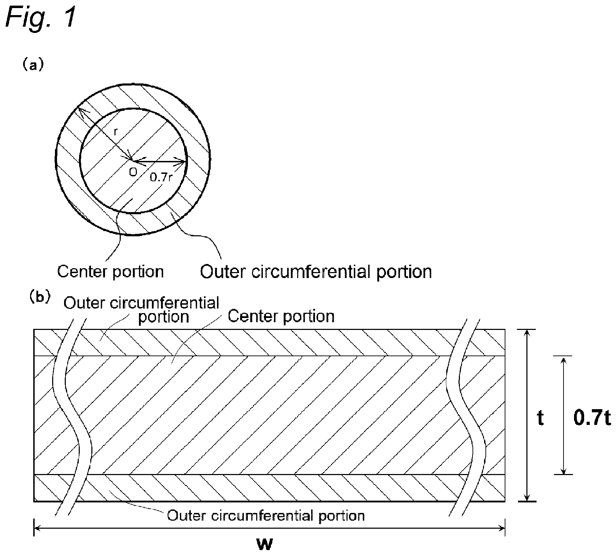

{Fig. 1}
Figs. 1(a) and 1(b) are explanatory diagrams schematically illustrating an outer circumferential portion and a center portion of a copper alloy wire in the present invention. Fig. 1(a) schematically illustrates the outer circumferential portion and the center portion when the center of a copper alloy round wire of the present invention in a transverse cross-section thereof is represented as O, and the radius thereof is represented as r (mm). The inner side from the center O to 0.7r is the center portion. Fig. 1(b) schematically illustrates the outer circumferential portion and the center portion when the width of a copper alloy rectangular wire of the present invention in a transverse cross-section thereof is represented as w (mm), and the height thereof (the thickness of the rectangular wire) is represented as t (mm). In the drawing, the inner side up to 0.7t is the center portion.

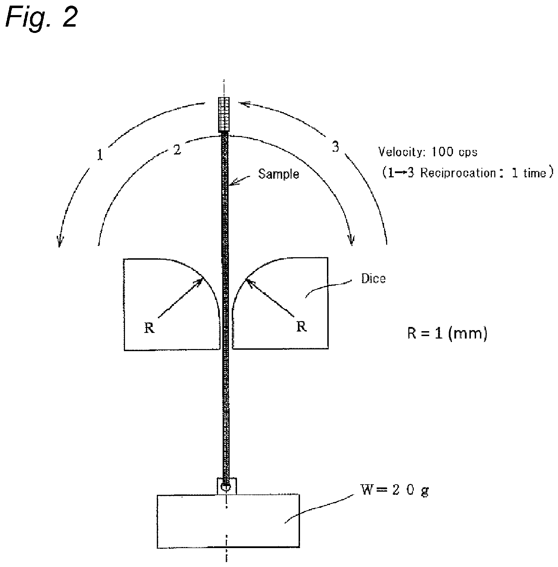

{Fig. 2}
Fig. 2 is a front view schematically showing the apparatus used in the test for measuring the number of repeating times at breakage in bending fatigue (the number of repeating times at breakage), which was conducted in the Examples.

MODE FOR CARRYING OUT THE INVENTION

The present embodiment of the present invention will be described in detail below.

[Alloy composition]

The copper alloy wire of the present embodiment of the present invention consists of at least one selected from the group consisting of: [1] Ag at a content of 0.1 to 4 mass%; and [2] at least one selected from the group consisting of Sn, Mg, Zn, In, Ni, Co, Zr, and Cr each at a content of 0.05 to 0.3 mass%, with the balance being Cu and unavoidable impurities. Herein, when the content of an alloy additive element is simply expressed in "percent (%)", this means "mass%". Also, there are no particular limitations on the total content of at least one alloy component selected from the group consisting of Sn, Mg, Zn, In, Ni, Co, Zr, and Cr. In order to prevent a noticeable decrease in the electrical conductivity of the copper alloy wire, the total content of at least one alloy component selected from the group consisting of Sn, Mg, Zn, In, Ni, Co, Zr, and Cr, in addition to Ag, is preferably 0.5 mass% or less.

The copper alloy wire of this embodiment contains Ag alone, or contains at least one selected from the group consisting of Sn, Mg, Zn, In, Ni, Co, Zr, and Cr alone, or contains both Ag and at least one selected from the group consisting of Sn, Mg, Zn, In, Ni, Co, Zr, and Cr.

These elements each are a solid solution strengthening-type or precipitation strengthening-type element, and when any of these elements is/are added to Cu, physical strength can be enhanced without lowering the electrical conductivity to a large extent.

As a result of this addition, the physical strength of the copper alloy wire itself is enhanced, and the resistance to bending fatigue is enhanced. Although the resistance to bending fatigue is generally proportional to tensile strength, if further working is applied in order to enhance the tensile strength, elongation is lowered, and the wire cannot be formed into an extra-fine copper alloy wire, such as a magnet wire. Herein, the bending strain exerted on the copper alloy wire at the time of bending fatigue increases toward the outer circumference of the wire, and the amount of bending strain decreases as the center is approached. According to this embodiment, the entirety of the wire maintains a semi-softened state. Thus, since elongation of the wire as a whole can be sufficiently secured, forming into an extra-fine copper alloy wire, such as a magnet wire, is enabled.

Among these elements, Ag is an element that can particularly enhance physical strength without lowering electrical conductivity, and a Cu-Ag-based alloy is preferably used as a copper alloy related to the present embodiment that is used, for example, in a magnet wire or the like. Ag is an exemplary essential additive element for the copper alloy related to the present embodiment. In this embodiment, the Ag content is set to 0.1 to 4%, preferably 0.5 to 2%. If the content of Ag is too small, sufficient physical strength cannot be obtained. Also, if the Ag content is too large, electrical conductivity is lowered, and also it becomes excessively high cost.

The at least one element selected from the group consisting of Sn, Mg, Zn, In, Ni, Co, Zr, and Cr is an another example of an essential alloying element in the copper alloy according to the present embodiment. In the present embodiment, the contents of those elements are, respectively, 0.05 to 0.3%, and preferably 0.05 % to 0.2%. If this content is too small as the respective content, the effect of strength enhancement owing to the addition of any of these elements cannot be expected in most cases. Also, if this content is too large, since the lowering of the electrical conductivity is too large, the resultant copper alloy is inappropriate as a copper alloy wire, such as a magnet wire.

These elements each are a solid solution strengthening-type or precipitation strengthening-type element, and when any of these elements is/are added to Cu, physical strength can be enhanced without lowering the electrical conductivity to a large extent. As a result of this addition, the physical strength of the copper alloy wire itself is enhanced, and the resistance to bending fatigue is enhanced.

[Crystal orientation]

The copper alloy wire of the present embodiment is characterized in that the <100> texture is 30% or more of the entire wire. Herein, the fact that the <100> texture is 30% or more of the entire wire means that the area ratio of grains having <100> orientation is 30% or more of the entire measurement area when the transverse cross-section of the wire illustrated in Fig. 1(a) is observed from the axis direction by an EBSD method. When the copper wire is subjected to drawing and heating, the <100> texture and the <111> texture are developed, but as a result of the investigation of the present inventor on extra-fine copper alloy wire having various textures, the inventor found that a copper alloy wire in which the <100> texture is occupied at 30% or more of the entire wire, preferably 50% or more, is excellent in elongation and tensile strength, and is also excellent in coil characteristics. In addition, when the <100> texture is too large, the physical strength slightly lowers, and thus the <100> texture is preferably less than 75% of the entire wire.

Further, even when the crystal orientation ratios of the metal textures of the entire wire are the same, in a case where there is gradient between the outer circumferential portion and the center portion of the wire (that is, there is a difference in degree of control of the crystal orientation), a difference between characteristics of a wire to be obtained occurs.

Herein, in a case where the copper alloy wire of the present embodiment is a round wire, when the radius of the circle of the transverse cross-section thereof is represented as r (mm), a region from the center O in the transverse cross-section toward the outermost surface of the wire up to 0.7r is considered as a center portion, and a region to the outermost surface of the wire outside the center portion is considered as an outer circumferential portion (see Fig. 1(a)).

Further, in a case where the copper alloy wire of the present embodiment is a rectangular wire, when the width of the rectangle of the transverse cross-section thereof is represented as w (mm) and the thickness (height of the rectangle) thereof is represented as t (mm), a region from the center side of the transverse cross-section toward the outermost surface of the wire up to 0.7t is considered as a center portion, and a region to the outermost surface of the wire outside the center portion is considered as an outer circumferential portion (see Fig. 1(b)).

In an embodiment of the present embodiment, the area ratio lo(100) of grains having <100> orientation in the outer circumferential portion with respect to the entire measurement area and the area ratio li(100) of grains having <100> orientation in the center portion with respect to the entire measurement area preferably satisfy the relationship represented by lo(100)/li(100) > 1.2. When this relationship is satisfied, coil formability is further enhanced. The reason for this is that bending at the time of coil formation is more easily endured. This embodiment is particularly suitable for the case of working a small-diameter coil having a small radius of bending.

Further, in another embodiment of the present embodiment, the relationship represented by lo(100)/li(100) < 0.8 is preferably satisfied. When this relationship is satisfied, the resistance to bending fatigue of the coil is further enhanced, and the service life of the coil is enhanced. The reason for this is that the physical strength of the outer circumferential portion, which easily undergoes vibration fatigue or bending fatigue, becomes higher. This embodiment is particularly suitable for a case where the wire diameter of the round wire is finer or the thickness of the rectangular wire is thinner, and a case where service life against bending is required.

In the present embodiment, preferably, of two embodiments, it is possible to select and form the suitable state of crystalline texture, that is, the aggregate state of <100> orientation different between the outer circumferential portion and the center portion, depending on necessary coil characteristics. The details of the forming method will be described later.

[EBSD method]

The observation and analysis of the crystal orientation in the present embodiment are conducted using the EBSD method. The EBSD method, which stands for electron backscatter diffraction, is a technique of crystal orientation analysis using reflected electron Kikuchi-line diffraction that occurs when a sample is irradiated with an electron beam under a scanning electron microscope (SEM).

In the EBSD measurement in the present embodiment, the transverse cross-section of the wire is scanned at a predetermined step, and then the orientation of each grain is measured (analyzed). Herein, in the present embodiment, based on the measurement results, a plane in which a deviation angle with <100> orientation is within $\pm 10$ degrees is defined as a <100> plane, and a grain which has a plane in which a deviation angle with <100> orientation is within $\pm 10$ degrees when the transverse cross-section of the wire is observed from the axis direction by the EBSD method is defined as a grain having <100> orientation. Based on these definitions, a value of the area of grains having the <100> plane is specified. Further, the area ratio (%) of grains having <100> orientation is calculated from the ratio of the area of grains having <100> orientation with respect to the entire measurement area when the transverse cross-section of the wire is observed from the axis direction by the EBSD method.

Herein, the entire measurement area indicates the total of areas obtained by scanning as described above.

The scan step may be appropriately determined depending on the size of the grain of a sample.

The measurement point of the sample is preferably set under the conditions that the measurement result representing the entire copper alloy wire sample can be obtained, or may be obtained by performing measurement on at least two points in the radial direction. However, the measurement point is preferably three points in total of the center point of the sample and two points facing each other with an equal interval in the radial direction, or three or more points. Particularly, in the case of an extra-fine wire as the present embodiment, the diameter is sufficiently small, and thus scanning can be easily performed on the entire diameter at a fine step. Therefore, it is preferable that the entire copper alloy wire sample in the diameter direction is scanned at a fine step, for example, at a step of about 0.02 $\mu$m, and the measured entire area is considered as the entire measurement area.

Information obtained by analysis of the grains by the EBSD measurement in this way includes information on a portion up to a depth of several 10 nm in which an electron beam enters the sample. However, since the information is sufficiently small with respect to the largeness of the area, which is being measured, in the specification, the information is considered as area information of grains. Further, since the average area of the grains varies depending on the axis direction (longitudinal direction, LD) of the wire, it is preferable to obtain an average by taking arbitrary points in the axis direction.

[Grain size of matrix of copper alloy wire]

In order to further enhance characteristics in the present embodiment, the grain size is preferably 0.2 $\mu$m or more but 5 $\mu$m or less. When the grain is too small, the grain is excessively fine, and thus work-hardening performance may be lowered and the elongation may be slightly lowered in some cases. On the other hand, when the grain size is too large, non-uniform deformation may easily occur and, of course, the elongation may be lowered in some cases.

[Production method]

The production method of the copper wire of the present embodiment will be described.

As discussed above, the shape of the copper alloy wire of the present embodiment is not limited to a round wire, and may also be a square wire or a rectangular wire. Then, these will be described below.

[Production method of a round wire]

First, the production method of a copper alloy round wire of the present embodiment includes, for example, the steps of: casting; cold-working (specifically, cold wire-drawing, and also referred to as intermediate cold-working); intermediate annealing; final cold-working; and final-annealing. Herein, the cold-working and the intermediate annealing may be performed in this order if necessary, or these steps may be repeated in this order two times or more. The number of repeating times of the cold-working and the intermediate annealing is not particularly limited, but is generally one to five times, and preferably two to four times. In a case where the size of the cast ingot and the final wire diameter are close to each other (for example, the working degree from the cast ingot to the final wire diameter is in the range of 0.5 to 4, that is, the size of the cast ingot is small or the final wire diameter is thick), it is not necessary to perform the intermediate annealing, and the intermediate annealing can be omitted. In this case, the cold-working as the intermediate wire-drawing after the intermediate annealing is also omitted.

[Casting]

Cu and an additive element of Ag, Sn, Mg, Zn, In, Ni, Co, Zr, Cr, or the like are melted and cast in a crucible. The atmosphere inside the crucible at the time of melting is preferably selected to be a vacuum or an inert gas atmosphere, such as nitrogen or argon, in order to prevent occurrence of oxides. There are no particular limitations on the casting method, and use may be made, for example, of such a continuous casting wire-drawing method, a transverse continuous casting machine or an upcast method. By means of the continuous casting wire-drawing method, steps can be carried out continuously from casting to wire-drawing, and a roughly-drawn rod is obtained with a diameter of generally about $\phi$ 8 to 23 mm.

On the other hand, in the case where no continuous casting wire-drawing method is utilized, a roughly-drawn rod having a diameter of generally about $\phi$ 8 to 23 mm is similarly obtained, by subjecting the billet (cast ingot) obtained by casting, to wire-drawing.

[Cold-working, intermediate annealing]

The cold-working and heating (intermediate annealing) are repeatedly performed, if necessary, on this roughly-drawn rod each at least one time in this order. When this roughly-drawn rod is subjected to cold-working and heating (intermediate annealing), the roughly-drawn rod is worked into a fine diameter wire having a diameter of generally about $\phi$ 0.1 mm to 0.01 mm.

However, in a case where a fine-diameter wire having a desired wire diameter can be obtained without performing such a step, the step may not be performed.

The working degree and the working rate in each cold-working will be described.

Each cold-working is performed such that a wire (roughly-drawn rod) in which a working degree ($\eta$) is within the range of 0.5 or more but 4 or less can be obtained.

Herein, the working degree ($\eta$) is defined as $\eta = \ln(S_0/S_1)$, when the cross-sectional area of the wire (or rod) before working is designated as $S_0$, and the cross-sectional area of the wire (or rod) after working is designated as $S_1$.

When the working degree is too small, the physical strength and the elongation are not sufficiently exhibited due to the heating (intermediate annealing) after working, and the number of steps increases. Therefore, since the energy consumption amount increases, the production efficiency is poor, which is not favorable. In addition, when the working degree is too large, the orientation property of the <100> texture (the area ratio of the grains having <100> orientation) becomes small to be less than 30%, and thus the <111> texture increases. Accordingly, the texture after the finish-annealing (final-annealing) is also affected and thus the elongation is lowered.

Herein, each cold-working may be performed at a plurality of times of cold-working passes. The number of passes of cold-working between two subsequent steps of heating (intermediate annealing) is not particularly limited, and is generally two to 40 times.

When the relationship of lo(100)/li(100) > 1.2 is intended to be satisfied, it is preferable that the working rate each time in each working pass in the intermediate cold-working until the step before the final cold-working is set to 12% or more but 35% or less, and only the final cold-working is performed at a working rate of 3% or more but less than 12%.

On the other hand, when the relationship of lo(100)/li(100) < 0.8 is intended to be satisfied, it is preferable that both the intermediate cold-working and the finish cold-working (final cold-working) are performed at a working rate each time in each working pass of 3% or more but less than 12%, respectively.

Herein, the working rate each time indicates an average working rate of a working pass each time in a plurality of working passes of the working step.

Even when the cold-working is performed at any one of two working rates, it is preferable that the intermediate cold-working is performed at a working degree $\eta$ in the cold-working step of the range of 0.5 or more but 4 or less.

The working rate (also referred to as a reduction ratio or a cross-section reduction rate) in each cold-working (intermediate cold-wire-drawing or finish cold-wire-drawing) step means a value calculated by the following formula, using a wire diameter $t_1$ (mm) of a wire before the wire-drawing step and a wire diameter $t_2$ (mm) of the wire after the wire-drawing step.

$$\text{Working rate } (\%) = \{(t_1 - t_2)/t_1\} \times 100 = \{1 - (t_2/t_1)\} \times 100$$

As described above, in the present embodiment, the degree of working is represented by a working degree in a case where working in a larger extent is performed and a working rate in a case where working in a smaller extent is performed.

In the producing method described in Patent Literature 3, only the working degree in the working before the final heating is controlled. To the contrary, in the producing method of the present embodiment, when all of the working degrees in each intermediate cold-wire-drawing and finish cold-wire-drawing as the cold-working between each of two heating steps are appropriately controlled, the orientation property of the recrystallized texture can be controlled. Thus, it is possible to obtain a copper alloy wire, in which a balance between the physical strength and the elongation is good and is at a high level, and which is also excellent in coil characteristics.

After each cold-working, if necessary, the intermediate annealing is performed. As described above, when the size of the cast ingot is close to the final wire diameter, the intermediate annealing may be omitted.

The heating method of performing the intermediate annealing may be roughly classified into a batch-type method and a continuous method.

Since the batch-type heating requires a long treatment time and a larger cost, this method is poor in productivity. However, since it is easy to perform the control of temperature or retention time period, it is easy to perform the control of characteristics. To the contrary, since heating and the wire-drawing can be continuously carried out in the continuous-type heating, continuous-type heating is excellent in productivity. However, since it is necessary to perform heating in the continuous-type heating in a very short time period, it is necessary to control the heating temperature and time period precisely, to realize characteristics stably. In this way, these heating methods have advantages and disadvantages as described above, and therefore, it is desirable to select the heating method according to the purpose.

Incidentally, in general, as the heating temperature becomes higher, heating is performed in a short time period, and as the heating temperature becomes lower, heating is performed in a long time period.

In a case where a batch-type intermediate annealing is performed, heating is performed in a heating furnace in an inert gas atmosphere, such as nitrogen or argon, at 300 to 800°C for 30 minutes to 2 hours. In particular, in a case where an element enhancing heat resistance, such as Ag or Zr, is added, heating is preferably performed at 400°C or higher but 800°C or lower for 30 minutes to 2 hours.

Hereinafter, the batch-type intermediate annealing is abbreviated as the batch annealing.

On the other hand, examples of the continuous-type heating include electrically heating-type heating and in-atmosphere running-type heating.

First, the electrically heating-type heating is a method of: providing electrode rings in the mid course of the wire-drawing step; applying an electric current to flow through the copper alloy wire passing among the electrode rings; and performing heating by the Joule heat generated by the copper alloy wire itself.

Then, the in-atmosphere running-type heating is a method of: providing a vessel for heating in the mid course of wire-drawing; and performing heating by passing a copper alloy wire in the atmosphere of the vessel for heating that has been heated to a predetermined temperature.

For both of those heating methods, it is preferable to perform heating in an inert gas atmosphere, in order to prevent oxidation of the copper alloy wire.

Regarding heating conditions in the case of performing a continuous-type intermediate annealing, heating is preferably performed at 400 to 850°C for 0.1 to 5 seconds. In particular, in a case where an element enhancing heat resistance, such as Ag or Zr, is added, heating is preferably performed at 500°C or higher but 850°C or lower for 0.1 to 5 seconds.

Hereinafter, the two types of continuous-type annealing of the electrically heating-type heating and the in-atmosphere running-type heating are abbreviated as electric current annealing and running annealing, respectively.

The intermediate annealing performed by any one of heating types is carried out on the copper wire such that the elongation of the copper wire becomes 15% or more. When insufficient heating is performed such that the elongation thereof becomes less than 15%, the sufficient removal of strain and recrystallization cannot be carried out, and thus a large amount of a worked texture of <111> remains. Therefore, sufficient elongation cannot be exhibited in a final product. In addition, preferably, as the heating as the intermediate annealing, it is preferable to perform heating while the temperature does not become higher by 100°C or higher than the recrystallization temperature of the copper alloy used as the copper alloy wire, thus to cause the wire to be in a semi-softened state. When heating is excessively performed so as to cause the wire to be in a softened state, the coarsening of grains occurs. Thus, non-uniform deformation may easily occur and sufficient elongation may not be exhibited in a final product in some cases.

[Finish cold-working (final cold-working)]

The wire, which has been subjected to the cold-working and the intermediate annealing, is subjected to finish cold-working to have a desired wire diameter. This finish cold-working is also performed in the range in which the working degree ($\eta$) of the copper wire is 0.5 or more but 4 or less, similarly to the intermediate cold-working. When the working degree is too small, working is not sufficiently performed, and thus the working effect to the copper wire is not sufficient. Further, the physical strength of the copper wire to be obtained after the finish-annealing is not sufficient. On the other hand, when the working degree is too large, it is not possible to obtain 30% or more of the <100> texture after the finish-annealing, and sufficient elongation cannot be obtained. Preferably, the finish cold-working is performed in the range in which the working degree ($\eta$) is 0.5 or more but 3 or less. When the finish cold-working is performed at this preferable working degree, the <100> texture becomes 50% or more, and it is possible to obtain a more excellent copper alloy wire having a tensile strength of 350 MPa or more and an elongation of 10% or more.

Furthermore, the working rate in each working pass of the finish cold-working in order to preferably control the value of lo(100)/li(100) is preferably set as described above, in the same manner as described in the section of the intermediate cold-working.

[Finish-annealing (final-annealing)]

The copper alloy wire that has been wire-drawn to a desired size (wire diameter) by the steps of the finish cold-working, is subjected to finish-annealing as the final-heating.

In the case of performing a batch-type finish-annealing, heating is performed at 300 to 500°C for 30 minutes to 2 hours. On the other hand, in the case of performing a continuous-type finish-annealing, heating is performed at 300 to 700°C for 0.1 to 5 seconds. In particular, in a case where an element enhancing heat resistance, such as Ag or Zr, is added, heating is performed at 350°C or higher but 500°C or lower in the case of the batch type. On the other hand, it is necessary to perform heating at 400°C or higher but 700°C or lower in the case of the continuous type.

Hereinafter, the batch-type finish-annealing is abbreviated as the batch annealing. In addition, the two types of continuous-type finish-annealing are abbreviated as electric current annealing and running annealing, respectively.

The heating of the finish-annealing is performed under the conditions that the copper alloy wire as a final product after the heating satisfies characteristics of a tensile strength of 350 MPa or more and an elongation of 10% or more. It is preferable that a semi-softened state is achieved by performing heating at a temperature at which complete softening is carried out, that is, at a temperature lower than the recrystallization temperature.

At this time, since characteristics of the tensile strength and the elongation after the heating that is the finish-annealing slightly vary depending on the composition of the copper alloy wire or the working rate, the heating temperature and the heating time period are adjusted such that the tensile strength of the copper alloy wire obtained by the heating that is the finish-annealing is 350 MPa or more and the elongation thereof is 10% or more.

[Production method of a rectangular wire]

Next, the production method of a copper alloy rectangular wire of the present embodiment will be described. The method of producing a copper alloy rectangular wire of the present embodiment is the same as the method of producing a round wire described above, except for containing rectangular wire-working. Specifically, the method of producing a rectangular wire of the present embodiment is carried out by performing the steps, for example, of: casting; cold-working (cold wire-drawing); rectangular wire-working; and final-heating (final-annealing), in this order. It is also the same as the method of producing a round wire that the intermediate annealing (intermediate heating) is carried out in the mid course of the cold-working and the rectangular wire-working, if necessary. The conditions of the steps of working and heating, such as casting, cold-working, intermediate annealing, and final-annealing, the preferred conditions thereof, and the number of repeating times of cold-working and intermediate annealing are the same as those for the method of producing a round wire.

[Rectangular wire-working]

Up to the steps before the rectangular wire-working, the production process is the same as that for the round wire, in which an ingot obtained by casting is subjected to cold-working (wire-drawing) to obtain a roughly-drawn rod having a round wire shape, and the roughly-drawn rod is further subjected to intermediate annealing if necessary. Regarding the rectangular wire-working, the round wire (roughly-drawn rod) thus obtained is subjected to cold-rolling using a rolling machine, cold-rolling using a cassette roller die, pressing, drawing, and the like. Through this rectangular wire-working, the transverse direction (TD) cross-section shape is worked into a rectangular shape, to obtain the shape of a rectangular wire. This rolling and the like are generally carried out in one to five passes. The reduction ratio in each pass and the total reduction ratio at the time of rolling and the like are not particularly limited, and may be appropriately set to obtain a desired rectangular wire size. Herein, the reduction ratio is the ratio of change in the thickness in the rolling direction upon performing the rectangular wire-working, and when the thickness before rolling is designated as $t_1$, and the thickness of the wire after rolling is designated as $t_2$, the reduction ratio (%) is represented by: $\{1 - (t_2/t_1)\} \times 100$. Further, in the present embodiment, the working degree $\eta$ in the rectangular wire-working is defined as $\eta = \ln(t_1/t_2)$. For example, this total reduction ratio can be adjusted to 10 to 90%, and the reduction ratio in each pass can be adjusted to 10 to 50%. Herein, in the present embodiment, there are no particular limitations on the cross-section shape of the rectangular wire, but the aspect ratio is generally 1 to 50, preferably 1 to 20, and more preferably 2 to 10. The aspect ratio (represented by w/t as described below) is the ratio of a shorter side to a longer side in the rectangle that forms the transverse direction (TD) cross-section of a rectangular wire. In regard to the size of the rectangular wire, a rectangular wire thickness t is equal to the shorter side of the rectangle that forms the transverse direction (TD) cross-section, and a rectangular wire width w is equal to the longer side of the rectangle that forms the transverse direction (TD) cross-section. The rectangular wire thickness t is generally 0.1 mm or less, preferably 0.07 mm or less, and more preferably 0.05 mm or less. The rectangular wire width w is generally 1 mm or less, preferably 0.7 mm or less, and more preferably 0.5 mm or less.

When this rectangular wire is subjected to coil working (winding) in the thickness direction, high tensile strength, elongation and electrical conductivity can be exhibited, similarly to the round wire according to the present embodiment. Herein, subjecting a rectangular wire to coil working in the thickness direction means that a rectangular wire is wound into a coil shape while taking the width w of the rectangular wire as the width of the coil.

[Production method of a square wire]

Furthermore, in the case of producing a square wire, it is enough to set the transverse direction (TD) cross-section to be a square (w = t), in the method of producing a rectangular wire.

[Other embodiments of the production methods of a rectangular wire and a square wire]

Instead of the production methods described above, a sheet or strip having a predetermined alloy composition is produced, and the sheet or strip is slit, to obtain a rectangular wire or square wire having a desired wire width.

This production process, for example, contains: casting; hot-rolling; cold-rolling; finish-annealing; and slitting. If necessary, the intermediate annealing may be carried out in the mid course of a plurality of cold-rollings. Slitting may be carried out before the finish-annealing, if necessary.

[Physical properties]

According to the producing method described above, a copper alloy wire having an area ratio of the <100> texture of 30% or more, preferably 50% or more (preferably, less than 75%) can be obtained. Hereinafter, unless otherwise specified, it is considered that the description is given for embodiments of both a round wire and a square wire.

The copper alloy wire of the present embodiment has a tensile strength of 350 MPa or more. When the tensile strength is too small, the physical strength is insufficient when the diameter is made finer, and the wire is poor in resistance to bending fatigue in some cases.

The copper alloy wire of the present embodiment preferably has an elongation of 10% to 30%. When the elongation is too small, defects, such as breakage, may occur at the time of forming into a coil in some cases.

The copper alloy wire of the present embodiment has an electrical conductivity of preferably 70 %IACS or more, more preferably 80 %IACS or more, and further preferably 90 %IACS or more. Since energy loss is small in the case of having a higher electrical conductivity, the copper alloy wire is preferable as, for example, a magnet wire. The copper alloy wire as a magnet wire needs to have an electrical conductivity of 70 %IACS or more, preferably 80 %IACS or more, and further preferably 90 %IACS or more.

The copper alloy wire of the present embodiment preferably has such a high elongation that the copper alloy wire can be formed as an extra-fine magnet wire. In addition, the copper alloy wire of the present embodiment preferably is high in resistance to bending fatigue (service life of the coil). The copper alloy wire of the present embodiment is preferably excellent in coil formability as other coil characteristics. Further, the copper alloy wire of the present embodiment preferably is high in electrical conductivity.

[Wire diameter or wire thickness, use]

There are no particular limitations on the wire diameter or the wire thickness of the copper alloy wire of the present embodiment. The wire diameter or the wire thickness is 0.1 mm or less, more preferably 0.07 mm or less, and even more preferably 0.05 mm or less; and 0.01 mm or more.

The use of the copper alloy wire of the present embodiment is not particularly limited. Examples of the use include an extra-fine magnet wire for use in speaker coils that are used in mobile phones, smart phones, and the like.

EXAMPLES

The present embodiment will be described in more detail based on examples given below.

[Examples and Comparative Examples of round wires]

With respect to the cast material, the copper alloy materials in Examples according to this invention and Comparative Examples having the respective alloy composition, as shown in Tables 1-1, 2-1 to 2-3, 4-1, and 5-1, each containing Ag at a content of 0.5 to 4 mass%, and/or at least one selected from the group consisting of Sn, Mg, Zn, In, Ni, Co, Zr, and Cr each at a content of 0.05 to 0.3 mass%, with the balance being Cu and unavoidable impurities, were cast into ingots (roughly-drawn rods) with diameters $\phi$ 8 to 22 mm, respectively, by a transverse-type continuous casting method.

The cold-working (intermediate cold-wire-drawing), the intermediate annealing (intermediate heating), the finish cold-working (finish cold-wire-drawing), and the finish-annealing (finish heating) were carried out on those roughly-drawn rods in this order, thereby for preparing each round wire sample (test material) having wire diameters as shown in each Table.

The heating of the intermediate annealing and the finish-annealing were carried out by any manner selected from three patterns of batch annealing, electric current annealing, and running annealing, each under a nitrogen atmosphere. In each Table, the types of the performed heating were presented as "batch," "electric current," and "running." The heating temperature and the heating time period of the heating were presented in each column. The intermediate annealing and the finish-annealing were presented in the performing order as Heating 1 → Heating 2 → Heating 3 → .... "X" in "Heating X" indicates the performing order (number) of the annealing (X-th). Of them, the heating performed finally is the finish-annealing. In the test examples presented in each Table, there are cases where the intermediate annealing was performed once to four times and the intermediate annealing was not performed at all. The value presented in the column of "Wire diameter" in the item of "Heating X" in each test example is the wire diameter of the wire after the cold-working (intermediate cold-wire-drawing or finish cold-wire-drawing) immediately before performing the X-th heating. The working degree in the cold-working (intermediate cold-wire-drawing or finish cold-wire-drawing) was presented in the column of "Working degree."

In Tables 2-4 to 2-6, the working degree in the cold-working (finish cold-wire-drawing) performed finally was presented in the column of "Working degree in final working."

In Table 5-1, the working rate in working per pass of the cold-working (intermediate cold-wire-drawing or finish cold-wire-drawing) was presented in the column of "Working rate per pass."

[Examples and Comparative Examples of rectangular wires]

A rectangular wire sample was prepared in the same manner as in the round wire, except that after the roughly-drawn rod obtained by cold-working (wire-drawing) the cast ingot was subjected to the intermediate annealing (Heating 1 in the table), the cold-working (wire-drawing) and the intermediate annealing (Heating 2 → Heating 3 → Heating 4 in the table) were performed each at least once, and then the finish-annealing (any of Heating 3, Heating 4, and Heating 5 in the table) was performed after performing the rectangular wire-working.

Regarding the rectangular wire-working, as shown in Table 3-1 or 3-2, a round wire before this rectangular wire-working was worked by cold-rolling into a rectangular wire such that the wire diameter $\phi$ (mm) was worked into a size of width w (mm) $\times$ thickness t (mm).

In Table 3-2, the working degree in the cold-working (finish cold-wire-drawing) performed finally was presented in the column of "Working degree in final working."

The production conditions for the copper alloy wires of Examples according to the present invention and the copper alloy wires of Comparative Examples, and the characteristics of the copper alloy wires thus obtained, are presented in Tables 1-1 to 5-2.

[Characteristics/Physical properties]

With respect to the thus-obtained samples of the round wires and the rectangular wires, characteristics were tested and evaluated.

The tensile strength (TS) and the elongation (El) were measured for the copper alloy wire after the finish-annealing, according to JIS Z2201 and Z2241, respectively. In the tables, these were represented as "Tensile strength (TS) after heating" and "Elongation (El) after heating," respectively. A case where the tensile strength was 350 MPa or more was judged as passing. A case where the elongation was 10% or more was judged as passing.

The grain size (GS) was measured by an intercept method (JIS G0551) based on microstructure observation on the transverse cross-section of each sample.

The crystal orientation of the recrystallized texture was measured and evaluated by an EBSD (electron backscatter diffraction) method, as follows. First, the entire transverse cross-section of a copper alloy wire sample was smoothed to be a plane, which can be measured by the EBSD method. Specifically, the observation surface of the sample was subjected to cross-section polisher (CP) working, electrolytic polishing, or the like, to be a smooth surface. Next, the transverse cross-section of each copper alloy wire sample was scanned at a step of 0.02 $\mu$m, and the orientation of each grain was analyzed. Herein, use was made of a measurement device, which was configured by using JSM-7001FA (manufactured by JEOL Ltd.) as an electron beam generation source and OIM 5.0 HIKARI (TSL) as an EBSD detector. The analysis was conducted by using analysis software OIM software (trade name) produced by TSL solutions Co., Ltd. The measurement conditions in the measurement device was set to, for example, measurement conditions in which the vacuum degree was set to about $10^{-4}$ to $10^{-5}$ Pa, the acceleration voltage was set to 20 to 30 V, and the reliability index (Confidence Index: CI value) as calculated with OIM software was set to 0.2 or more. When the measurement is performed while the CI value is set to 0.2 or more, it is possible to obtain more accurate measurement results. Based on such the measurement results, a plane in which a deviation angle with <100> orientation would be within ±10 degrees was defined as a <100> plane, a grain which had a plane in which a deviation angle with <100> orientation would be within ±10 degrees when the transverse cross-section of each copper alloy wire sample was observed from the axis direction by the EBSD method, was judged as a grain having <100> orientation, and then the values of these areas were specified. Further, the area ratio (%) of grains having <100> orientation was calculated from the ratio of the area of grains having <100> orientation specified in this way with respect to the entire measurement area. In each Table, this area ratio is represented as a <100> area ratio. Similarly, a plane in which a deviation angle with <111> orientation would be within ±10 degrees was defined as a <111> plane, and then the area ratio (%) of grains having <111> orientation was calculated. In each Table, this area ratio is represented as a <111> area ratio.

Further, when the radius of the transverse cross-section of each copper alloy round wire sample is represented as r (mm), a region from the center O in the transverse cross-section toward the outermost surface of the wire up to 0.7r is considered as a center portion, and a region to the outermost surface of the wire outside the center portion is considered as an outer circumferential portion (see Fig. 1(a)). In the same manner as described above, the area ratio Io(100) of grains having <100> orientation in the outer circumferential portion with respect to the entire measurement area and the area ratio Ii(100) of grains having <100> orientation in the center portion with respect to the entire measurement area, were obtained by the EBSD method. From these values, the value of Io(100)/Ii(100) was calculated and then presented in Table 5-2.

Regarding the service life of the coil, the number of repeating times at breakage in bending fatigue until the test material of the copper alloy wire was broken was measured by performing a bending fatigue test using a device illustrated in Fig. 2, and the service life of the coil was evaluated based on the number of repeating times at breakage in bending fatigue. In this test, first, as illustrated in Fig. 2, a test specimen of a copper alloy wire, as a sample, with a final wire diameter $\phi$ or wire thickness t was sandwiched between dies, and a load was applied thereon by hanging a weight (W) of 20 g at the lower end of the specimen in order to suppress deflection of the wire. In the case of the rectangular wire, the sample was mounted to be sandwiched between the two dies in the wire thickness direction (ND). The upper end of the specimen was fixed with a connecting jig. While having the specimen maintained in this state, the specimen was bent 90° on the left side and the right side, respectively, bending was repeatedly carried out at a speed of 100 times per minute, and the number of repeating times at breakage in bending was measured for each specimen, i.e. the respective sample. Regarding the number of repeating times in bending, one reciprocation of $1 \rightarrow 2 \rightarrow 3$ in Fig. 2 was counted as one time, and the distance between the two dies was set to 1 mm so that the specimen of the copper alloy wire would not be compressed in the test. Determination of breakage was made such that the specimen was judged to be broken when the weight hung at the lower end of the specimen dropped. Furthermore, the radius of bending (R) was set to 1 mm, depending on the curvature of the dies. A case where the number of repeating times at breakage in bending until the wire was broken (the number of repeating times at breakage in bending fatigue) was 2,501 times or more was rated as "AA (particularly excellent)," a case where the number of repeating times at breakage in bending was 2,001 to 2,500 times was rated as "A (excellent)," a case where the number of repeating times at breakage in bending was 1,501 to 2,000 times was rated as "B (good)," a case where the number of repeating times at breakage in bending was 1,001 to 1,500 times was rated as "C (acceptable)," and a case where the number of repeating times at breakage in bending was 1,000 times or less was rated as "D (poor)."

The electrical conductivity (EC) was measured, according to JIS H0505. The electrical conductivity of 70 %IACS or more was rated as passing, the electrical conductivity of 80 %IACS or more was rated as good, the electrical conductivity of 90 %IACS or more was rated as excellent, and the electrical conductivity of less than 70 %IACS was rated as failed.

Regarding the coil formability, the frequency of occurrence of wire breakage when 100 km of the test material of the copper alloy wire was wound on a coil having a diameter of 5 mm ($\phi$5 mm) was tested, and the evaluation was carried out at wire breakage frequency per 100 km. A case where the frequency of occurrence of wire breakage was 0 times or more but less than 0.3 times was rated as "A (excellent)," a case where the frequency of occurrence of wire breakage was 0.3 times or more but less than 0.6 times was rated as "B (good)," a case where the frequency of occurrence of wire breakage was 0.6 times or more but less than 1.0 times was rated as "C (acceptable)," and a case where the frequency of occurrence of wire breakage was 1.0 times or more was rated as "D (poor)."

The comprehensive evaluation was determined from the tensile strength, the elongation, and the coil characteristics (the service life of the coil, the coil formability, and the electrical conductivity) described above, and a sample excellent as a copper alloy wire for an extra-fine coil at a low cost was rated as "A (excellent)," while other samples were successively rated as "B (good)," "C (acceptable)," and "D (poor)."

Characteristics of round wire samples (Examples 1 to 10) according to the present examples and round wire samples (Comparative Examples 1 to 10), in which the Cu-2% Ag alloy wire was worked to have a final wire diameter of 0.1 mm ($\phi$0.1 mm), and subjected to heating, were measured and evaluated, and the results thereof are presented in Tables 1-1 to 1-3.

Table 1-1

| | Composition* Ag | Ingot diameter | Heating 1 | | | | | Heating 2 | | | | |
|---|---|---|---|---|---|---|---|---|---|---|---|---|
| | mass% | mm | Wire diameter mm | Working degree | Manner | Heating temp. °C | Heating period | Wire diameter mm | Working degree | Manner | Heating temp. °C | Heating period |
| Ex 1 | 2 | 10 | 2.6 | 2.7 | Running | 650 | 1 sec | 0.5 | 3.3 | Running | 650 | 1 sec |
| Ex 2 | 2 | 10 | 2.6 | 2.7 | Running | 650 | 1 sec | 0.5 | 3.3 | Running | 650 | 1 sec |
| Ex 3 | 2 | 10 | 2.6 | 2.7 | Running | 650 | 1 sec | 0.5 | 3.3 | Running | 650 | 1 sec |
| Ex 4 | 2 | 10 | 2.6 | 2.7 | Running | 650 | 1 sec | 0.5 | 3.3 | Running | 650 | 1 sec |
| Ex 5 | 2 | 10 | 2.6 | 2.7 | Running | 650 | 1 sec | 1 | 1.9 | Running | 650 | 1 sec |
| Ex 6 | 2 | 10 | 2.6 | 2.7 | Running | 650 | 1 sec | 1 | 1.9 | Running | 650 | 1 sec |
| Ex 7 | 2 | 10 | 2.6 | 2.7 | Running | 650 | 1 sec | 1 | 1.9 | Running | 650 | 1 sec |
| Ex 8 | 2 | 10 | 2.6 | 2.7 | Running | 650 | 1 sec | 0.65 | 2.8 | Running | 650 | 1 sec |
| Ex 9 | 2 | 10 | 2.6 | 2.7 | Running | 650 | 1 sec | 0.69 | 2.7 | Running | 650 | 1 sec |
| Ex 10 | 2 | 10 | 2.6 | 2.7 | Running | 650 | 1 sec | 1 | 1.9 | Running | 650 | 1 sec |
| Cex 1 | 2 | 10 | 2.6 | 2.7 | Running | 650 | 1 sec | 0.8 | 2.4 | Running | 650 | 1 sec |
| Cex 2 | 2 | 10 | 1.5 | 3.8 | Running | 650 | 1 sec | 0.1 | 5.4 | Running | 550 | 1 sec |
| Cex 3 | 2 | 10 | 3 | 2.4 | Running | 650 | 1 sec | 0.1 | 6.8 | Running | 550 | 1 sec |
| Cex 4 | 2 | 10 | 8 | 0.4 | Running | 650 | 1 sec | 0.1 | 8.8 | Running | 550 | 1 sec |
| Cex 5 | 2 | 10 | 0.1 | 9.2 | Running | 550 | 1 sec | | | - | | |
| Cex 6 | 2 | 10 | 0.8 | 5.1 | Running | 650 | 1 sec | 0.1 | 4.2 | Running | 550 | 1 sec |
| Cex 7 | 2 | 10 | 0.5 | 6.0 | Running | 650 | 1 sec | 0.1 | 3.2 | Electric current | 550 | 1 sec |

(continued)

| Composition* | | Ingot diameter | Heating 1 | | | | | Heating 2 | | | | |
| Ag | | | Wire diameter | Working degree | Manner | Heating temp. | Heating period | Wire diameter | Working degree | Manner | Heating temp. | Heating period |
| mass% | | mm | mm | | | °C | | mm | | | °C | |
| C ex 8 | 2 | 10 | 0.3 | 7.0 | Running | 650 | 1 sec | 0.1 | 2.2 | Electric current | 550 | 1 sec |
| C ex 9 | 2 | 10 | 2.6 | 2.7 | Running | 650 | 1 sec | 0.65 | 2.8 | Electric current | 650 | 1 sec |
| C ex 10 | 2 | 10 | 0.5 | 6.0 | Running | 850 | 1 sec | 0.1 | 3.2 | Electric current | 550 | 1 sec |

Note: * The balance was Cu and unavoidable impurities, and "-" means not added.
"Ex" means Example according to this invention, and "C ex" means Comparative example. The same is applied to hereinafter.

Table 1-2

| | Heating 3 | | | | | Heating 4 | | | | |
|---|---|---|---|---|---|---|---|---|---|---|
| | Wire diameter | Working degree | Manner | Heating temp. | Heating period | Wire diameter | Working degree | Manner | Heating temp. | Heating period |
| | mm | | | °C | | mm | | | °C | |
| Ex 1 | 0.13 | 2.7 | Running | 650 | 1 sec | 0.1 | 0.5 | Running | 550 | 1 sec |
| Ex 2 | 0.17 | 2.2 | Running | 650 | 1 sec | 0.1 | 1.1 | Running | 550 | 1 sec |
| Ex 3 | 0.2 | 1.8 | Running | 650 | 1 sec | 0.1 | 1.4 | Running | 550 | 1 sec |
| Ex 4 | 0.33 | 0.8 | Running | 650 | 1 sec | 0.1 | 2.4 | Running | 550 | 1 sec |
| Ex 5 | 0.4 | 1.8 | Running | 650 | 1 sec | 0.1 | 2.8 | Running | 550 | 1 sec |
| Ex 6 | 0.5 | 1.4 | Running | 650 | 1 sec | 0.1 | 3.2 | Running | 550 | 1 sec |
| Ex 7 | 0.55 | 1.2 | Running | 650 | 1 sec | 0.1 | 3.4 | Running | 550 | 1 sec |
| Ex 8 | 0.1 | 3.7 | Running | 650 | 1 sec | - | | | | |
| Ex 9 | 0.1 | 3.9 | Running | 650 | 1 sec | - | | | | |
| Ex 10 | 0.4 | 1.8 | Running | 850 | 1 sec | 0.1 | 2.8 | Running | 550 | 1 sec |
| C ex 1 | 0.1 | 4.2 | Running | 650 | 1 sec | - | | | | |
| C ex 2 | - | | | | | - | | | | |
| C ex 3 | - | | | | | - | | | | |
| C ex 4 | - | | | | | - | | | | |
| C ex 5 | - | | | | | - | | | | |
| C ex 6 | - | | | | | - | | | | |
| C ex 7 | - | | | | | - | | | | |
| C ex 8 | - | | | | | - | | | | |

(continued)

| | Heating 3 | | | | | Heating 4 | | | | |
|---|---|---|---|---|---|---|---|---|---|---|
| | Wire diameter | Working degree | Manner | Heating temp. | Heating period | Wire diameter | Working degree | Manner | Heating temp. | Heating period |
| | mm | | | °C | | mm | | | °C | |
| C ex 9 | 0.2 | 2.4 | Running | <u>400</u> | 1 sec | 0.1 | 1.4 | Running | 550 | 1 sec |
| C ex 10 | - | | | | | - | | | | |

Table 1-3

| | | Characteristics | | | | | | | |
|---|---|---|---|---|---|---|---|---|---|
| | Grain size | <100> area ratio | <111> area ratio | E1 after heating | TS after heating | EC | Coil service life | Coil formability | Comprehensive evaluation |
| | μm | % | % | % | MPa | %IACS | | | |
| Ex 1 | 1.5 | 76 | 8 | 21 | 367 | 93 | B | A | B |
| Ex 2 | 2.2 | 71 | 12 | 24 | 391 | 92 | A | A | A |
| Ex 3 | 2.1 | 70 | 14 | 23 | 391 | 93 | A | A | A |
| Ex 4 | 1.8 | 68 | 10 | 18 | 392 | 92 | A | B | A |
| Ex 5 | 1.1 | 55 | 21 | 16 | 407 | 92 | A | B | A |
| Ex 6 | 0.8 | 47 | 16 | 14 | 407 | 93 | A | C | B |
| Ex 7 | 0.5 | 43 | 23 | 14 | 407 | 92 | A | C | B |
| Ex 8 | 0.1 | 41 | 30 | 12 | 400 | 93 | A | C | B |
| Ex 9 | 0.1 | 38 | 20 | 12 | 400 | 93 | A | C | B |
| Ex 10 | 8.2 | 55 | 10 | 12 | 400 | 93 | A | C | B |
| C ex 1 | 0.1 | 25 | 52 | 6 | 376 | 94 | B | D | D |
| C ex 2 | 0.1 | 28 | 50 | 8 | 365 | 93 | B | D | D |
| C ex 3 | 0.2 | 15 | 56 | 8 | 366 | 94 | B | D | D |
| C ex 4 | 0.1 | 12 | 61 | 7 | 371 | 92 | B | D | D |
| C ex 5 | 0.2 | 10 | 61 | 6 | 370 | 93 | B | D | D |
| C ex 6 | 0.1 | 25 | 62 | 6 | 366 | 93 | B | D | D |
| C ex 7 | 2.2 | 23 | 67 | 6 | 371 | 94 | B | D | D |

(continued)

| | | Characteristics | | | | | | | |
|---|---|---|---|---|---|---|---|---|---|
| | Grain size | <100> area ratio | <111> area ratio | E1 after heating | TS after heating | EC | Coil service life | Coil formability | Comprehensive evaluation |
| | μm | % | % | % | MPa | %IACS | | | |
| C ex 8 | 2.2 | <u>23</u> | 65 | <u>6</u> | 371 | 94 | B | D | D |
| C ex 9 | 1.5 | <u>28</u> | 56 | <u>6</u> | 365 | 93 | B | D | D |
| C ex 10 | 7.5 | <u>22</u> | 50 | <u>8</u> | 367 | 93 | B | D | D |

In all of Examples 1 to 10, since the working and heating conditions were properly adjusted such that the area ratio of the texture of <100> orientation became 30% or more, both the tensile strength and the elongation were high, that is, 350 MPa or more and 10% or more, respectively, and good characteristics of the service life of the coil and coil formability were also exhibited. In particular, in Examples 2 to 5 in which the final working degree ($\eta$) in the finish cold-working before the finish-annealing was 0.5 or more but 3 or less, the area ratio of the <100> texture was 50% or more, the elongation was high, that is, 15% or more, and better characteristics of the service life of the coil were exhibited. In Example 1, in which the area ratio of the <100> texture was 75% or more, as compared with other examples, the physical strength was not so high. In Example 6 and 7, in which the final working degree ($\eta$) in the finish cold-working before the finish-annealing was more than 3 but less than 3.5, as compared with Examples 2 to 5, the elongation was not so high. Further, since the grain size becomes finer, that is, 0.1 $\mu$m, in Examples 8 and 9, in which the final working degree ($\eta$) in the finish cold-working before the finish-annealing was a value from 3.5 to 4.0, as compared with other examples, the elongation was not so high. Also in Example 10, in which the heating condition was high such that the intermediate annealing temperature was 850°C, as compared with other Examples, the elongation was not so high. For these reasons, in these Examples 8, 9, and 10, as compared with other examples, the coil formability was not so high.

Contrary to the above, in Comparative Examples 1 to 6, since the final cold-working degree was too large, the <100> texture was small and the elongation was poor. In Comparative Examples 7 and 8, since the working degree ($\eta$) before the final cold-working intermediate annealing was more than 4, that is, too large, similarly, the texture of <111> orientation largely remained, the area ratio of the texture of <100> orientation was small, and the elongation was poor. In Comparative Example 9, since the intermediate annealing (Heating 3) was not sufficient, and thus working strain could not be sufficiently removed so that the working strain was held until the next step, the area ratio of the <100> texture was small and the elongation was poor. In Comparative Example 10, since the working degree before heating was too high and the temperature of the intermediate annealing was also too high, grains were coarsened, and the elongation was poor. In all of these Comparative Examples 1 to 10, the coil formability was poor as well as the elongation.

In this way, according to the present embodiment, by properly adjusting the heating temperature and working degree, it is possible to control the <100> texture, and to obtain a copper alloy wire that has the physical strength and the elongation at a higher level and is also excellent in coil characteristics.

The examples and comparative examples of copper alloy round wires having various alloy compositions other than a Cu-2% Ag alloy are presented in Tables 2-1 to 2-9.

In Tables 2-4 to 2-6, in the column of "Working degree in final working," the working degrees in the final finish-cold-working (x-th, x = final) performed immediately before heating x (x-th, x = final) finally performed among "Heatings 1 to 5" were presented.

Table 2-1

| | Composition* | | | | | | | | | Ingot diameter |
| | Ag | Mg | Sn | In | Zn | Ni | Cr | Zr | Co | |
| | mass% | mass% | mass% | mass% | mass% | mass% | mass% | mass% | mass% | mm |
| Ex 11 | 0.1 | - | - | - | - | - | - | - | - | 10 |
| Ex 12 | 0.1 | - | - | - | - | - | - | - | - | 22 |
| Ex 13 | 0.1 | - | - | - | - | - | - | - | - | 10 |
| Ex 14 | 0.5 | - | - | - | - | - | - | - | - | 10 |
| Ex 15 | 0.5 | - | - | - | - | - | - | - | - | 10 |
| Ex 16 | 0.5 | - | - | - | - | - | - | - | - | 22 |
| Ex 17 | 1 | - | - | - | - | - | - | - | - | 10 |
| Ex 18 | 1 | - | - | - | - | - | - | - | - | 10 |
| Ex 19 | 1 | - | - | - | - | - | - | - | - | 16 |
| Ex 20 | 3 | - | - | - | - | - | - | - | - | 10 |
| Ex 21 | 3 | - | - | - | - | - | - | - | - | 10 |
| Ex 22 | 3 | - | - | - | - | - | - | - | - | 16 |
| Ex 23 | 4 | - | - | - | - | - | - | - | - | 8 |
| Ex 24 | 4 | - | - | - | - | - | - | - | - | 10 |
| Ex 25 | 4 | - | - | - | - | - | - | - | - | 20 |
| Ex 26 | - | 0.1 | - | - | - | - | - | - | - | 10 |
| Ex 27 | - | 0.1 | - | - | - | - | - | - | - | 20 |
| Ex 28 | - | 0.3 | - | - | - | - | - | - | - | 10 |
| Ex 29 | - | 0.3 | - | - | - | - | - | - | - | 10 |
| Ex 30 | - | - | 0.1 | - | - | - | - | - | - | 20 |

Note: * The balance was Cu and unavoidable impurities, and "-" means not added.
"Ex" means Example according to this invention, and "C ex" means Comparative example.    The same is applied to hereinafter.

Table 2-1 (continued-1)

| | Composition* | | | | | | | | | Ingot diameter |
| | Ag | Mg | Sn | In | Zn | Ni | Cr | Zr | Co | diameter |
|---|---|---|---|---|---|---|---|---|---|---|
| | mass% | mass% | mass% | mass% | mass% | mass% | mass% | mass% | mass% | mm |
| Ex 31 | - | - | 0.3 | - | - | - | - | - | - | 12 |
| Ex 32 | - | - | - | 0.1 | - | - | - | - | - | 8 |
| Ex 33 | - | - | - | 0.3 | - | - | - | - | - | 16 |
| Ex 34 | - | - | - | - | 0.1 | - | - | - | - | 10 |
| Ex 35 | - | - | - | - | 0.3 | - | - | - | - | 8 |
| Ex 36 | - | - | - | - | - | 0.1 | - | - | - | 10 |
| Ex 37 | - | - | - | - | - | 0.3 | - | - | - | 20 |
| Ex 38 | - | - | - | - | - | - | 0.1 | - | - | 10 |
| Ex 39 | - | - | - | - | - | - | 0.3 | - | - | 8 |
| Ex 40 | - | - | - | - | - | - | - | 0.1 | - | 10 |
| Ex 41 | - | - | - | - | - | - | - | 0.3 | - | 22 |
| Ex 42 | - | - | - | - | - | - | - | - | 0.1 | 10 |
| Ex 43 | - | - | - | - | - | - | - | - | 0.3 | 10 |

EP 3 042 972 B1

Table 2-1 (continued-2)

| | Heating 1 | | | | | Heating 2 | | | | |
|---|---|---|---|---|---|---|---|---|---|---|
| | Wire diameter | Working degree | Manner | Heating temp. | Heating period | Wire diameter | Working degree | Manner | Heating temp. | Heating period |
| | mm | | | °C | | mm | | | °C | |
| Ex 11 | 2.6 | 2.7 | Butch | 420 | 1 hr | 0.5 | 3.3 | Butch | 430 | 1 hr |
| Ex 12 | 10 | 1.6 | Running | 550 | 1 sec | 4 | 1.8 | Running | 500 | 1 sec |
| Ex 13 | 2 | 3.2 | Butch | 450 | 1 hr | 0.3 | 3.8 | Running | 500 | 1 sec |
| Ex 14 | 2.6 | 2.7 | Butch | 420 | 1 hr | 0.5 | 3.3 | Butch | 420 | 1 hr |
| Ex 15 | 2 | 3.2 | Running | 500 | 1 sec | 0.4 | 3.2 | Running | 500 | 1 sec |
| Ex 16 | 8 | 2.0 | Butch | 430 | 30 min | 2.6 | 2.2 | Butch | 420 | 30 min |
| Ex 17 | 2.6 | 2.7 | Butch | 450 | 1 hr | 0.5 | 3.3 | Running | 550 | 1 sec |
| Ex 18 | 2 | 3.2 | Electric current | 600 | 1 sec | 0.3 | 3.8 | Electric current | 800 | 1 sec |
| Ex 19 | 2.6 | 3.6 | Butch | 430 | 1 hr | 0.4 | 3.7 | Butch | 440 | 1 hr |
| Ex 20 | 2 | 3.2 | Butch | 520 | 30 min | 0.3 | 3.8 | Butch | 800 | 30 min |
| Ex 21 | 2.6 | 2.7 | Butch | 550 | 2 hr | 0.5 | 3.3 | Butch | 550 | 2 hr |
| Ex 22 | 2.6 | 3.6 | Running | 700 | 1 sec | 0.45 | 3.5 | Running | 700 | 1 sec |
| Ex 23 | 1.5 | 3.3 | Running | 720 | 1 sec | 0.25 | 3.6 | Running | 700 | 1 sec |
| Ex 24 | 2.6 | 2.7 | Running | 700 | 0.5 sec | 0.9 | 2.1 | Running | 700 | 0.5 sec |
| Ex 25 | 3.2 | 3.7 | Butch | 550 | 1 hr | 0.5 | 3.7 | Butch | 550 | 1 hr |
| Ex 26 | 2.6 | 2.7 | Butch | 420 | 1 hr | 0.5 | 3.3 | Running | 500 | 1 sec |
| Ex 27 | 5 | 2.8 | Butch | 430 | 30 min | 1 | 3.2 | Running | 500 | 2 sec |
| Ex 28 | 2 | 3.2 | Butch | 380 | 2 hr | 0.5 | 2.8 | Butch | 380 | 2 hr |
| Ex 29 | 2.6 | 2.7 | Running | 500 | 1 sec | 0.4 | 3.7 | Running | 500 | 1 sec |
| Ex 30 | 5 | 2.8 | Butch | 300 | 1 hr | 2.6 | 1.3 | Electric current | 500 | 3 sec |

Table 2-1 (continued-3)

| | Heating 1 | | | | | Heating 2 | | | | |
|---|---|---|---|---|---|---|---|---|---|---|
| | Wire diameter | Working degree | Manner | Heating temp. | Heating period | Wire diameter | Working degree | Manner | Heating temp. | Heating period |
| | mm | | | °C | | mm | | | °C | |
| Ex 31 | 2.6 | 3.1 | Running | 420 | 1 sec | 0.6 | 2.9 | Running | 420 | 1 sec |
| Ex 32 | 2 | 2.8 | Butch | 400 | 1 hr | 0.4 | 3.2 | Butch | 300 | 1 hr |
| Ex 33 | 2.6 | 3.6 | Butch | 400 | 1 hr | 0.5 | 3.3 | Electric current | 450 | 0.3 sec |
| Ex 34 | 1.5 | 3.8 | Running | 400 | 0.5 sec | 0.25 | 3.6 | Running | 480 | 0.5 sec |
| Ex 35 | 2.6 | 2.2 | Electric current | 460 | 5 sec | 0.65 | 2.8 | Running | 450 | 5 sec |
| Ex 36 | 2 | 3.2 | Running | 500 | 1 sec | 0.4 | 3.2 | Butch | 420 | 2 hr |
| Ex 37 | 5 | 2.8 | Butch | 430 | 1 hr | 1 | 3.2 | Butch | 400 | 1 hr |
| Ex 38 | 2 | 3.2 | Electric current | 480 | 1 sec | 0.3 | 3.8 | Butch | 400 | 1 hr |
| Ex 39 | 2.6 | 2.2 | Running | 480 | 2 sec | 1 | 1.9 | Running | 500 | 2 sec |
| Ex 40 | 2.6 | 2.7 | Butch | 430 | 30 min | 1.5 | 1.1 | Butch | 400 | 30 min |
| Ex 41 | 8 | 2.0 | Butch | 400 | 1 hr | 2.6 | 2.2 | Running | 530 | 4 sec |
| Ex 42 | 2.6 | 2.7 | Electric current | 520 | 0.5 sec | 0.5 | 3.3 | Running | 530 | 0.5 sec |
| Ex 43 | 2.6 | 2.7 | Running | 550 | 1 sec | 0.4 | 3.7 | Butch | 400 | 30 min |

EP 3 042 972 B1

Table 2-2

| | Composition* | | | | | | | | | Ingot diameter |
| | Ag | Mg | Sn | In | Zn | Ni | Cr | Zr | Co | |
| | mass% | mass% | mass% | mass% | mass% | mass% | mass% | mass% | mass% | mm |
| Ex 44 | 0.5 | 0.1 | - | - | - | - | - | - | - | 10 |
| Ex 45 | 0.5 | 0.1 | - | - | - | - | - | - | - | 22 |
| Ex 46 | 0.5 | 0.2 | - | - | - | - | - | - | - | 8 |
| Ex 47 | 0.5 | 0.2 | - | - | - | - | - | - | - | 10 |
| Ex 48 | 1 | 0.05 | - | - | - | - | - | - | - | 22 |
| Ex 49 | 1 | 0.1 | - | - | - | - | - | - | - | 10 |
| Ex 50 | 1 | 0.1 | - | - | - | - | - | - | - | 10 |
| Ex 51 | 1 | 0.2 | - | - | - | - | - | - | - | 8 |
| Ex 52 | 2 | 0.1 | - | - | - | - | - | - | - | 22 |
| Ex 53 | 2 | 0.15 | - | - | - | - | - | - | - | 10 |
| Ex 54 | 2 | 0.2 | - | - | - | - | - | - | - | 10 |
| Ex 55 | 3 | 0.05 | - | - | - | - | - | - | - | 16 |
| Ex 56 | 3 | 0.1 | - | - | - | - | - | - | - | 10 |
| Ex 57 | 3 | 0.15 | - | - | - | - | - | - | - | 10 |
| Ex 58 | 4 | 0.05 | - | - | - | - | - | - | - | 20 |
| Ex 59 | 4 | 0.1 | - | - | - | - | - | - | - | 8 |
| Ex 60 | 4 | 0.15 | - | - | - | - | - | - | - | 10 |

Table 2-2 (continued-1)

| | Composition* | | | | | | | | | Ingot diameter |
| | Ag mass% | Mg mass% | Sn mass% | In mass% | Zn mass% | Ni mass% | Cr mass% | Zr mass% | Co mass% | mm |
|---|---|---|---|---|---|---|---|---|---|---|
| Ex 61 | 2 | - | 0.05 | - | - | - | - | - | - | 8 |
| Ex 62 | - | 0.15 | - | - | 0.2 | - | - | - | - | 22 |
| Ex 63 | - | 0.1 | - | 0.1 | - | - | - | - | - | 10 |
| Ex 64 | 1 | - | - | 0.1 | - | - | - | - | - | 8 |
| Ex 65 | 1 | - | - | - | - | - | - | 0.1 | - | 10 |
| Ex 66 | 1 | 0.05 | - | - | - | - | - | 0.1 | - | 10 |
| Ex 67 | - | 0.1 | - | - | - | - | - | 0.1 | - | 20 |
| Ex 68 | 1 | 0.1 | - | - | - | - | - | - | - | 5 |
| Ex 69 | 0.2 | - | - | - | - | - | 0.1 | 0.05 | - | 10 |
| Ex 70 | - | - | - | - | - | - | 0.1 | 0.1 | - | 8 |
| Ex 71 | - | 0.15 | - | - | 0.2 | - | - | - | - | 15 |
| Ex 72 | 2 | - | 0.1 | 0.1 | - | - | 0.05 | - | - | 8 |
| Ex 73 | - | 0.1 | 0.05 | - | 0.1 | - | - | - | - | 10 |
| Ex 74 | 1 | - | - | - | 0.1 | 0.1 | - | 0.05 | - | 6 |

Table 2-2 (continued-2)

| | Heating 1 | | | | | Heating 2 | | | | |
|---|---|---|---|---|---|---|---|---|---|---|
| | Wire diameter | Working degree | Manner | Heating temp. | Heating period | Wire diameter | Working degree | Manner | Heating temp. | Heating period |
| | mm | | | °C | | mm | | | °C | |
| Ex 44 | 2.6 | 2.7 | Running | 530 | 2 sec | 0.4 | 3.7 | Running | 570 | 2 sec |
| Ex 45 | 8 | 2.0 | Butch | 480 | 1 hr | 1.5 | 3.3 | Electric current | 580 | 1 sec |
| Ex 46 | 2 | 2.8 | Butch | 500 | 1 hr | 0.3 | 3.8 | Butch | 440 | 1 hr |
| Ex 47 | 2 | 3.2 | Electric current | 630 | 1 sec | 0.5 | 2.8 | Electric current | 650 | 1 sec |
| Ex 48 | 8 | 2.0 | Butch | 450 | 2 hr | 2.6 | 2.2 | Butch | 460 | 2 hr |
| Ex 49 | 2.6 | 2.7 | Running | 650 | 1 sec | 0.8 | 2.4 | Running | 630 | 1 sec |
| Ex 50 | 2 | 3.2 | Butch | 500 | 30 min | 0.4 | 3.2 | Butch | 480 | 30 min |
| Ex 51 | 2.6 | 2.2 | Running | 600 | 2 sec | 1 | 1.9 | Running | 600 | 2 sec |
| Ex 52 | 8 | 2.0 | Butch | 530 | 30 min | 2.6 | 2.2 | Butch | 540 | 30 min |
| Ex 53 | 2 | 3.2 | Running | 650 | 1 sec | 0.4 | 3.2 | Butch | 530 | 30 min |
| Ex 54 | 2.6 | 2.7 | Running | 650 | 1 sec | 0.5 | 3.3 | Running | 650 | 1 sec |
| Ex 55 | 2.6 | 3.6 | Running | 610 | 1 sec | 0.45 | 3.5 | Running | 610 | 1 sec |
| Ex 56 | 2.6 | 2.7 | Running | 700 | 1 sec | 0.4 | 3.7 | Running | 680 | 1 sec |
| Ex 57 | 2 | 3.2 | Butch | 520 | 2 hr | 0.4 | 3.2 | Butch | 500 | 2 hr |
| Ex 58 | 3.2 | 3.7 | Butch | 550 | 1 hr | 0.5 | 3.7 | Butch | 550 | 1 hr |
| Ex 59 | 1.5 | 3.3 | Running | 700 | 1 sec | 0.25 | 3.6 | Butch | 530 | 1 hr |
| Ex 60 | 1.5 | 3.8 | Running | 730 | 0.5 sec | 0.25 | 3.6 | Electric current | 720 | 0.3 sec |

Table 2-2 (continued-3)

| | Heating 1 | | | | | Heating 2 | | | | |
|---|---|---|---|---|---|---|---|---|---|---|
| | Wire diameter | Working degree | Manner | Heating temp. | Heating period | Wire diameter | Working degree | Manner | Heating temp. | Heating period |
| | mm | | | °C | | mm | | | °C | |
| Ex 61 | 1.5 | 3.3 | Running | 650 | 1 sec | 0.25 | 3.6 | Running | 660 | 5 sec |
| Ex 62 | 8 | 2.0 | Butch | 400 | 30 min | 2.6 | 2.2 | Butch | 420 | 30 min |
| Ex 63 | 2 | 3.2 | Butch | 400 | 1 hr | 1 | 1.4 | Running | 480 | 1 sec |
| Ex 64 | 2 | 2.8 | Electric current | 650 | 0.5 sec | 0.4 | 3.2 | Electric current | 650 | 0.5 sec |
| Ex 65 | 2.6 | 2.7 | Running | 650 | 2 sec | 0.6 | 2.9 | Running | 670 | 2 sec |
| Ex 66 | 2 | 3.2 | Electric current | 650 | 0.3 sec | 0.4 | 3.2 | Electric current | 650 | 0.5 sec |
| Ex 67 | 8 | 1.8 | Butch | 420 | 1 hr | 2.6 | 2.2 | Butch | 430 | 1 hr |
| Ex 68 | 0.7 | 3.9 | Running | 650 | 2 sec | 0.1 | 3.9 | Butch | 380 | 2 hr |
| Ex 69 | 2.6 | 2.7 | Butch | 480 | 1 hr | 1.5 | 1.1 | Running | 570 | 2 sec |
| Ex 70 | 2 | 2.8 | Butch | 400 | 1 hr | 0.3 | 3.8 | Running | 670 | 2 sec |
| Ex 71 | 5 | 2.2 | Electric current | 520 | 0.5 sec | 2 | 1.8 | Butch | 420 | 30 min |
| Ex 72 | 2.6 | 2.2 | Running | 650 | 2 sec | 1.5 | 1.1 | Butch | 530 | 30 min |
| Ex 73 | 4 | 1.8 | Electric current | 480 | 0.3 sec | 1 | 2.8 | Electric current | 520 | 0.5 sec |
| Ex 74 | 1.5 | 2.8 | Electric current | 650 | 0.5 sec | 0.5 | 2.2 | Running | 650 | 2 sec |

Table 2-3

| | Composition* | | | | | | | | | Ingot diameter |
| | Ag | Mg | Sn | In | Zn | Ni | Cr | Zr | Co | |
| | mass% | mass% | mass% | mass% | mass% | mass% | mass% | mass% | mass% | mm |
|---|---|---|---|---|---|---|---|---|---|---|
| C ex 11 | 0.5 | - | - | - | - | - | - | - | - | 10 |
| C ex 12 | 1 | - | - | - | - | - | - | - | - | 10 |
| C ex 13 | 1 | - | - | - | - | - | - | - | - | 16 |
| C ex 14 | 1 | - | - | - | - | - | - | - | - | 10 |
| C ex 15 | 3 | - | - | - | - | - | - | - | - | 20 |
| C ex 16 | 3 | - | - | - | - | - | - | - | - | 10 |
| C ex 17 | 3 | - | - | - | - | - | - | - | - | 20 |
| C ex 18 | - | 0.1 | - | - | - | - | - | - | - | 10 |
| C ex 19 | - | - | 0.2 | - | - | - | - | - | - | 20 |
| C ex 20 | - | - | - | 0.1 | - | - | - | - | - | 10 |
| C ex 21 | - | - | - | - | 0.1 | | - | - | - | 8 |
| C ex 22 | - | - | - | - | - | 0.1 | - | - | - | 10 |
| C ex 23 | - | - | - | - | - | - | 0.1 | - | - | 8 |
| C ex 24 | - | - | - | - | - | - | - | 0.1 | - | 10 |
| C ex 25 | - | - | - | - | - | - | - | - | 0.1 | 8 |

Table 2-3 (continued-1)

| | Composition* | | | | | | | | | Ingot diameter |
| | Ag | Mg | Sn | In | Zn | Ni | Cr | Zr | Co | |
| | mass% | mass% | mass% | mass% | mass% | mass% | mass% | mass% | mass% | mm |
| C ex 26 | 0.05 | - | - | - | - | - | - | - | - | 10 |
| C ex 27 | - | 0.03 | - | - | - | - | - | - | - | 20 |
| C ex 28 | - | 0.4 | - | - | - | - | - | - | - | 10 |
| C ex 29 | - | - | 0.04 | - | - | - | - | - | - | 20 |
| C ex 30 | - | - | 0.5 | - | - | - | - | - | - | 8 |
| C ex 31 | - | - | - | 0.04 | - | - | - | - | - | 20 |
| C ex 32 | - | - | - | - | 0.03 | - | - | - | - | 8 |
| C ex 33 | - | - | - | - | - | 0.6 | - | - | - | 10 |
| C ex 34 | - | - | - | - | - | - | 0.03 | - | - | 20 |
| C ex 35 | - | - | - | - | - | - | - | 0.02 | - | 20 |
| C ex 36 | - | - | - | - | - | - | - | - | 0.8 | 10 |
| C ex 37 | - | - | 0.5 | - | 0.3 | - | - | - | - | 10 |
| C ex 38 | 0.05 | - | 0.03 | - | - | 0.05 | - | - | - | 15 |
| C ex 39 | 3 | 0.1 | 0.5 | - | - | - | - | - | - | 15 |
| C ex 40 | 5 | - | 0.3 | - | - | 0.4 | - | - | - | 10 |

Table 2-3 (continued-2)

| | Heating 1 | | | | | Heating 2 | | | | |
|---|---|---|---|---|---|---|---|---|---|---|
| | Wire diameter | Working degree | Manner | Heating temp. | Heating period | Wire diameter | Working degree | Manner | Heating temp. | Heating period |
| | mm | | | °C | | mm | | | °C | |
| C ex 11 | 0.05 | 10.6 | Running | 500 | 0.5 sec | | | - | | |
| C ex 12 | 0.9 | 4.8 | Running | 550 | 1 sec | 0.1 | 4.4 | Running | 550 | 1 sec |
| C ex 13 | 2.6 | 3.6 | Butch | 500 | 1 hr | 0.5 | 3.3 | Butch | 800 | 1 hr |
| C ex 14 | 2.6 | 2.7 | Running | 550 | 1 sec | 0.5 | 3.3 | Running | 350 | 1 sec |
| C ex 15 | 0.04 | 12.4 | Running | 610 | 1 sec | | | - | | |
| C ex 16 | 2.6 | 2.7 | Electric current | 650 | 2 sec | 0.4 | 3.7 | Electric current | 400 | 2 sec |
| C ex 17 | 2.6 | 4.1 | Butch | 550 | 1 hr | 1 | 1.9 | Running | 680 | 1 sec |
| C ex 18 | 2 | 3.2 | Running | 550 | 1 sec | 0.3 | 3.8 | Running | 520 | 1 sec |
| C ex 19 | 0.05 | 12.0 | Butch | 280 | 2 hr | | | - | | |
| C ex 20 | 2.6 | 2.7 | Running | 520 | 1 sec | 0.5 | 3.3 | Running | 250 | 1 sec |
| C ex 21 | 1.5 | 3.3 | Butch | 400 | 2 hr | 1 | 0.8 | Butch | 420 | 2 hr |
| C ex 22 | 5 | 1.4 | Butch | 430 | 30 min | 0.04 | 9.7 | Butch | 300 | 30 min |
| C ex 23 | 1.5 | 3.3 | Electric current | 600 | 2 sec | 0.25 | 3.6 | Butch | 400 | 30 min |
| C ex 24 | 0.08 | 9.7 | Butch | 400 | 1 hr | | | - | | |
| C ex 25 | 1.5 | 3.3 | Running | 250 | 1 sec | 0.3 | 3.2 | Butch | 400 | 1 hr |

Table 2-3 (continued-3)

| | Heating 1 | | | | | Heating 2 | | | | |
|---|---|---|---|---|---|---|---|---|---|---|
| | Wire diameter | Working degree | Manner | Heating temp. | Heating period | Wire diameter | Working degree | Manner | Heating temp. | Heating period |
| | mm | | | °C | | mm | | | °C | |
| C ex 26 | 2 | 3.2 | Butch | 480 | 1 hr | 0.5 | 2.8 | Running | 570 | 2 sec |
| C ex 27 | 10 | 1.4 | Butch | 430 | 30 min | 2.6 | 2.7 | Running | 480 | 1 sec |
| C ex 28 | 2.6 | 2.7 | Running | 480 | 1 sec | 0.5 | 3.3 | Butch | 400 | 1 hr |
| C ex 29 | 8 | 1.8 | Butch | 420 | 1 hr | 2.6 | 2.2 | Butch | 430 | 30 min |
| C ex 30 | 2 | 2.8 | Butch | 430 | 30 min | 0.5 | 2.8 | Running | 480 | 1 sec |
| C ex 31 | 1 | 6.0 | Running | 480 | 1 sec | 0.5 | 1.4 | Electric current | 500 | 0.3 sec |
| C ex 32 | 2.6 | 2.2 | Electric current | 510 | 0.5 sec | 1.5 | 1.1 | Running | 480 | 1 sec |
| C ex 33 | 5 | 1.4 | Butch | 430 | 30 min | 1 | 3.2 | Running | 500 | 0.5 sec |
| C ex 34 | 8 | 1.8 | Running | 480 | 1 sec | 2 | 2.8 | Electric current | 480 | 1 sec |
| C ex 35 | 10 | 1.4 | Butch | 480 | 1 hr | 1.5 | 3.8 | Running | 570 | 2 sec |
| C ex 36 | 1.5 | 3.8 | Running | 480 | 1 sec | 0.25 | 3.6 | Butch | 430 | 30 min |
| C ex 37 | 1 | 4.6 | Butch | 420 | 1 hr | 0.5 | 1.4 | Butch | 430 | 30 min |
| C ex 38 | 2.6 | 3.5 | Butch | 480 | 1 hr | 0.4 | 3.7 | Butch | 500 | 2 hr |
| C ex 39 | 2.2 | 3.8 | Running | 700 | 1 sec | 0.35 | 3.7 | Butch | 530 | 1 hr |
| C ex 40 | 2 | 3.2 | Running | 730 | 0.5 sec | 0.45 | 3.0 | Electric current | 730 | 0.5 sec |

Table 2-4

| | Heating 3 | | | | | Heating 4 | | | | |
|---|---|---|---|---|---|---|---|---|---|---|
| | Wire diameter | Working degree | Manner | Heating temp. | Heating period | Wire diameter | Working degree | Manner | Heating temp. | Heating period |
| | mm | | | °C | | mm | | | °C | |
| Ex 11 | 0.1 | 3.2 | Butch | 370 | 1 hr | | | - | | |
| Ex 12 | 0.8 | 3.2 | Butch | 430 | 30 min | 0.12 | 3.8 | Electric current | 500 | 1 sec |
| Ex 13 | 0.08 | 2.6 | Butch | 370 | 30 min | | | - | | |
| Ex 14 | 0.1 | 3.2 | Butch | 430 | 1 hr | 0.05 | 1.4 | Butch | 370 | 1 hr |
| Ex 15 | 0.06 | 3.8 | Running | 500 | 1 sec | | | - | | |
| Ex 16 | 0.5 | 3.3 | Butch | 430 | 30 min | 0.1 | 3.2 | Butch | 430 | 30 min |
| Ex 17 | 0.1 | 3.2 | Butch | 450 | 1 hr | 0.03 | 2.4 | Butch | 385 | 30 min |
| Ex 18 | 0.06 | 3.2 | Electric current | 620 | 1 sec | | | - | | |
| Ex 19 | 0.06 | 3.8 | Butch | 440 | 1 hr | 0.04 | 0.8 | Butch | 390 | 1 hr |
| Ex 20 | 0.06 | 3.2 | Butch | 420 | 30 min | | | - | | |
| Ex 21 | 0.1 | 3.2 | Butch | 500 | 2 hr | 0.03 | 2.4 | Butch | 420 | 2 hr |
| Ex 22 | 0.08 | 3.5 | Running | 610 | 1 sec | | | - | | |
| Ex 23 | 0.05 | 3.2 | Running | 650 | 1 sec | | | - | | |
| Ex 24 | 0.2 | 3.0 | Butch | 550 | 1 hr | 0.08 | 1.8 | Running | 650 | 0.5 sec |
| Ex 25 | 0.1 | 3.2 | Butch | 800 | 1 hr | 0.04 | 1.8 | Butch | 450 | 1 hr |

Table 2-4 (continued-1)

| | Heating 3 | | | | | Heating 4 | | | | |
|---|---|---|---|---|---|---|---|---|---|---|
| | Wire diameter | Working degree | Manner | Heating temp. | Heating period | Wire diameter | Working degree | Manner | Heating temp. | Heating period |
| | mm | | | °C | | mm | | | °C | |
| Ex 26 | 0.1 | 3.2 | Butch | 400 | 1 hr | 0.03 | 2.4 | Butch | 340 | 30 min |
| Ex 27 | 0.3 | 2.4 | Running | 520 | 2 sec | 0.05 | 3.6 | Running | 430 | 2 sec |
| Ex 28 | 0.1 | 3.2 | Butch | 400 | 2 hr | 0.04 | 1.8 | Butch | 300 | 2 hr |
| Ex 29 | 0.06 | 3.8 | Running | 450 | 1 sec | | | - | | |
| Ex 30 | 0.5 | 3.3 | Electric current | 500 | 3 sec | 0.1 | 3.2 | Electric current | 500 | 3 sec |
| Ex 31 | 0.1 | 3.6 | Running | 420 | 1 sec | 0.04 | 1.8 | Running | 420 | 1 sec |
| Ex 32 | 0.08 | 3.2 | Butch | 300 | 1 hr | | | - | | |
| Ex 33 | 0.1 | 3.2 | Butch | 300 | 1 hr | 0.03 | 2.4 | Butch | 300 | 1 hr |
| Ex 34 | 0.05 | 3.2 | Running | 400 | 0.5 sec | | | - | | |
| Ex 35 | 0.15 | 2.9 | Electric current | 480 | 1 sec | 0.025 | 3.6 | Electric current | 380 | 0.5 sec |
| Ex 36 | 0.07 | 3.5 | Butch | 300 | 2 hr | | | - | | |
| Ex 37 | 0.2 | 3.2 | Butch | 400 | 1 hr | 0.08 | 1.8 | Butch | 300 | 1 hr |
| Ex 38 | 0.05 | 3.6 | Running | 400 | 1 sec | | | - | | |
| Ex 39 | 0.3 | 2.4 | Butch | 400 | 1 hr | 0.1 | 2.2 | Electric current | 520 | 2 sec |
| Ex 40 | 0.3 | 3.2 | Butch | 430 | 30 min | 0.06 | 3.2 | Butch | 350 | 30 min |
| Ex 41 | 1 | 1.9 | Butch | 420 | 1 hr | 0.15 | 3.8 | Running | 520 | 4 sec |
| Ex 42 | 0.1 | 3.2 | Electric current | 540 | 0.5 sec | 0.03 | 2.4 | Electric current | 400 | 0.5 sec |
| Ex 43 | 0.06 | 3.8 | Running | 400 | 1 sec | | | - | | |

Table 2-4 (continued-2)

| | Heating 5 | | | | | Working degree in final working |
|---|---|---|---|---|---|---|
| | Wire diameter | Working degree | Manner | Heating temp. | Heating period | |
| | mm | | | °C | | |
| Ex 11 | - | | | | | 3.2 |
| Ex 12 | 0.08 | 0.8 | Butch | 370 | 1 hr | 0.8 |
| Ex 13 | - | | | | | 2.6 |
| Ex 14 | - | | | | | 1.4 |
| Ex 15 | - | | | | | 3.8 |
| Ex 16 | 0.02 | 3.2 | Butch | 370 | 30 min | 3.2 |
| Ex 17 | - | | | | | 2.4 |
| Ex 18 | - | | | | | 3.2 |
| Ex 19 | - | | | | | 0.8 |
| Ex 20 | - | | | | | 3.2 |
| Ex 21 | - | | | | | 2.4 |
| Ex 22 | - | | | | | 3.5 |
| Ex 23 | - | | | | | 3.2 |
| Ex 24 | - | | | | | 1.8 |
| Ex 25 | - | | | | | 1.8 |

Table 2-4 (continued-3)

| | Heating 5 | | | | | Working degree in final working |
|---|---|---|---|---|---|---|
| | Wire diameter | Working degree | Manner | Heating temp. | Heating period | |
| | mm | | | °C | | |
| Ex 26 | - | | | | | 2.4 |
| Ex 27 | - | | | | | 3.6 |
| Ex 28 | - | | | | | 1.8 |
| Ex 29 | - | | | | | 3.8 |
| Ex 30 | 0.07 | 0.7 | Electric current | 430 | 3 sec | 0.7 |
| Ex 31 | - | | | | | 1.8 |
| Ex 32 | - | | | | | 3.2 |
| Ex 33 | - | | | | | 2.4 |
| Ex 34 | - | | | | | 3.2 |
| Ex 35 | - | | | | | 3.6 |
| Ex 36 | - | | | | | 3.5 |
| Ex 37 | - | | | | | 1.8 |
| Ex 38 | - | | | | | 3.6 |
| Ex 39 | 0.02 | 3.2 | Running | 380 | 2 sec | 3.2 |
| Ex 40 | - | | | | | 3.2 |
| Ex 41 | 0.05 | 2.2 | Running | 450 | 4 sec | 2.2 |
| Ex 42 | - | | | | | 2.4 |
| Ex 43 | - | | | | | 3.8 |

Table 2-5

| | Heating 3 | | | | | Heating 4 | | | | |
|---|---|---|---|---|---|---|---|---|---|---|
| | Wire diameter | Working degree | Manner | Heating temp. | Heating period | Wire diameter | Working degree | Manner | Heating temp. | Heating period |
| | mm | | | °C | | mm | | | °C | |
| Ex 44 | 0.06 | 3.8 | Running | 500 | 2 sec | - | | | | |
| Ex 45 | 0.3 | 3.2 | Electric current | 600 | 0.5 sec | 0.05 | 3.6 | Electric current | 500 | 0.5 sec |
| Ex 46 | 0.08 | 2.6 | Butch | 700 | 1 hr | 0.02 | 2.8 | Butch | 400 | 1 hr |
| Ex 47 | 0.1 | 3.2 | Electric current | 620 | 1 sec | 0.04 | 1.8 | Electric current | 500 | 1 sec |
| Ex 48 | 1 | 1.9 | Butch | 460 | 2 hr | 0.14 | 3.9 | Butch | 450 | 2 hr |
| Ex 49 | 0.2 | 2.8 | Running | 620 | 1 sec | 0.06 | 2.4 | Running | 550 | 1 sec |
| Ex 50 | 0.1 | 2.8 | Butch | 520 | 30 min | 0.03 | 2.4 | Butch | 400 | 30 min |
| Ex 51 | 0.3 | 2.4 | Running | 600 | 2 sec | 0.1 | 2.2 | Running | 600 | 2 sec |
| Ex 52 | 0.4 | 3.7 | Butch | 480 | 30 min | 0.07 | 3.5 | Butch | 400 | 30 min |
| Ex 53 | 0.1 | 2.8 | Electric current | 660 | 0.2 sec | 0.04 | 1.8 | Electric current | 550 | 2 sec |
| Ex 54 | 0.33 | 0.8 | Running | 650 | 1 sec | 0.1 | 2.4 | Running | 550 | 1 sec |
| Ex 55 | 0.08 | 3.5 | Running | 610 | 1 sec | - | | | | |
| Ex 56 | 0.06 | 3.8 | Running | 600 | 1 sec | - | | | | |
| Ex 57 | 0.07 | 3.5 | Butch | 420 | 2 hr | - | | | | |
| Ex 58 | 0.1 | 3.2 | Butch | 700 | 1 hr | 0.04 | 1.8 | Butch | 450 | 1 hr |
| Ex 59 | 0.05 | 3.2 | Running | 650 | 1 sec | - | | | | |
| Ex 60 | 0.05 | 3.2 | Running | 650 | 0.5 sec | - | | | | |

Table 2-5 (continued-1)

| | Heating 3 | | | | | Heating 4 | | | | |
|---|---|---|---|---|---|---|---|---|---|---|
| | Wire diameter | Working degree | Manner | Heating temp. | Heating period | Wire diameter | Working degree | Manner | Heating temp. | Heating period |
| | mm | | | °C | | mm | | | °C | |
| Ex 61 | 0.07 | 2.5 | Running | 580 | 1 sec | - | | | | |
| Ex 62 | 0.4 | 3.7 | Electric current | 480 | 0.3 sec | 0.07 | 3.5 | Butch | 320 | 30 min |
| Ex 63 | 0.4 | 1.8 | Running | 480 | 1 sec | 0.1 | 2.8 | Running | 420 | 1 sec |
| Ex 64 | 0.08 | 3.2 | Electric current | 550 | 0.5 sec | - | | | | |
| Ex 65 | 0.09 | 3.8 | Running | 540 | 2 sec | - | | | | |
| Ex 66 | 0.1 | 2.8 | Running | 630 | 2 sec | 0.04 | 1.8 | Electric current | 550 | 0.2 sec |
| Ex 67 | 0.6 | 2.9 | Electric current | 650 | 0.5 sec | 0.1 | 3.6 | Butch | 410 | 1 hr |
| Ex 68 | - | | | | | - | | | | |
| Ex 69 | 0.65 | 1.7 | Butch | 480 | 1 hr | 0.1 | 3.7 | Running | 570 | 2 sec |
| Ex 70 | 0.08 | 2.6 | Running | 500 | 2 sec | - | | | | |
| Ex 71 | 0.3 | 3.8 | Electric current | 520 | 0.5 sec | 0.08 | 2.6 | Butch | 420 | 30 min |
| Ex 72 | 0.4 | 2.6 | Electric current | 660 | 0.2 sec | 0.1 | 2.8 | Electric current | 550 | 2 sec |
| Ex 73 | 0.2 | 3.2 | Butch | 420 | 30 min | 0.03 | 3.8 | Butch | 320 | 30 min |
| Ex 74 | 0.1 | 3.2 | Butch | 500 | 30 min | 0.05 | 1.4 | Running | 550 | 1 sec |

Table 2-5 (continued-2)

| | Heating 5 | | | | | Working degree in final working |
|---|---|---|---|---|---|---|
| | Wire diameter | Working degree | Manner | Heating temp. | Heating period | |
| | mm | | | °C | | |
| Ex 44 | | | - | | | 3.8 |
| Ex 45 | | | - | | | 3.6 |
| Ex 46 | | | - | | | 2.8 |
| Ex 47 | | | - | | | 1.8 |
| Ex 48 | 0.09 | 0.9 | Butch | 380 | 2 hr | 0.9 |
| Ex 49 | | | - | | | 2.4 |
| Ex 50 | | | - | | | 2.4 |
| Ex 51 | 0.02 | 3.2 | Running | 550 | 2 sec | 3.2 |
| Ex 52 | | | - | | | 3.5 |
| Ex 53 | | | - | | | 1.8 |
| Ex 54 | | | - | | | 2.4 |
| Ex 55 | | | - | | | 3.5 |
| Ex 56 | | | - | | | 3.8 |
| Ex 57 | | | - | | | 3.5 |
| Ex 58 | | | - | | | 1.8 |
| Ex 59 | | | - | | | 3.2 |
| Ex 60 | | | - | | | 3.2 |

Table 2-5 (continued-3)

| | Heating 5 | | | | | Working degree in final working |
|---|---|---|---|---|---|---|
| | Wire diameter | Working degree | Manner | Heating temp. | Heating period | |
| | mm | | | °C | | |
| Ex 61 | - | | | | | 2.5 |
| Ex 62 | - | | | | | 3.5 |
| Ex 63 | 0.02 | 3.2 | Running | 350 | 1 sec | 3.2 |
| Ex 64 | - | | | | | 3.2 |
| Ex 65 | - | | | | | 3.8 |
| Ex 66 | - | | | | | 1.8 |
| Ex 67 | 0.02 | 3.2 | Butch | 360 | 1 hr | 3.2 |
| Ex 68 | - | | | | | 3.9 |
| Ex 69 | 0.04 | 1.8 | Butch | 380 | 2 hr | 1.8 |
| Ex 70 | - | | | | | 2.6 |
| Ex 71 | 0.05 | 0.9 | Running | 350 | 1 sec | 0.9 |
| Ex 72 | - | | | | | 2.8 |
| Ex 73 | - | | | | | 3.8 |
| Ex 74 | - | | | | | 1.4 |

Table 2-6

| | Heating 3 | | | | | Heating 4 | | | | |
|---|---|---|---|---|---|---|---|---|---|---|
| | Wire diameter | Working degree | Manner | Heating temp. | Heating period | Wire diameter | Working degree | Manner | Heating temp. | Heating period |
| | mm | | | °C | | mm | | | °C | |
| C ex 11 | - | | | | | - | | | | |
| C ex 12 | 0.03 | 2.4 | Running | 450 | 1 sec | - | | | | |
| C ex 13 | 0.05 | 4.6 | Running | 450 | 1 sec | - | | | | |
| C ex 14 | 0.1 | 3.2 | Running | 550 | 1 sec | 0.08 | 0.4 | Running | 450 | 1 sec |
| C ex 15 | - | | | | | - | | | | |
| C ex 16 | 0.06 | 3.8 | Electric current | 580 | 2 sec | - | | | | |
| C ex 17 | 0.3 | 2.4 | Running | 680 | 1 sec | 0.06 | 3.2 | Butch | 420 | 1 hr |
| C ex 18 | 0.03 | 4.6 | Electric current | 400 | 2 sec | - | | | | |
| C ex 19 | - | | | | | - | | | | |
| C ex 20 | 0.07 | 3.9 | Electric current | 400 | 1 sec | - | | | | |
| C ex 21 | 0.25 | 2.8 | Electric current | 530 | 0.6 sec | 0.03 | 4.2 | Butch | 300 | 30 min |
| C ex 22 | - | | | | | - | | | | |
| C ex 23 | 0.03 | 4.2 | Electric current | 400 | 0.2 sec | - | | | | |
| C ex 24 | - | | | | | - | | | | |
| C ex 25 | 0.06 | 3.2 | Running | 400 | 1 sec | - | | | | |

Table 2-6 (continued-1)

| | Heating 3 | | | | | Heating 4 | | | | |
|---|---|---|---|---|---|---|---|---|---|---|
| | Wire diameter | Working degree | Manner | Heating temp. | Heating period | Wire diameter | Working degree | Manner | Heating temp. | Heating period |
| | mm | | | °C | | mm | | | °C | |
| C ex 26 | 0.2 | 1.8 | Butch | 480 | 1 hr | 0.1 | 1.4 | Electric current | 570 | 1 sec |
| C ex 27 | 0.6 | 2.9 | Butch | 430 | 30 min | 0.1 | 3.6 | Butch | 300 | 1 hr |
| C ex 28 | 0.08 | 3.7 | Running | 480 | 1 sec | | | - | | |
| C ex 29 | 1.5 | 1.1 | Butch | 400 | 1 hr | 0.8 | 1.3 | Butch | 400 | 1 hr |
| C ex 30 | 0.08 | 3.7 | Running | 350 | 1 sec | | | - | | |
| C ex 31 | 0.1 | 3.2 | Butch | 430 | 30 min | 0.05 | 1.4 | Running | 380 | 0.5 sec |
| C ex 32 | 0.5 | 2.2 | Butch | 400 | 2 hr | 0.1 | 3.2 | Electric current | 500 | 0.3 sec |
| C ex 33 | 0.1 | 4.6 | Running | 480 | 1 sec | | | - | | |
| C ex 34 | 0.3 | 3.8 | Butch | 430 | 1 hr | 0.08 | 2.6 | Butch | 300 | 1 hr |
| C ex 35 | 0.3 | 3.2 | Butch | 480 | 1 hr | 0.1 | 2.2 | Butch | 420 | 1 hr |
| C ex 36 | 0.05 | 3.2 | Butch | 320 | 2 hr | | | - | | |
| C ex 37 | 0.2 | 1.8 | Electric current | 500 | 0.3 sec | 0.1 | 1.4 | Butch | 480 | 1 hr |
| C ex 38 | 0.07 | 3.5 | Butch | 370 | 30 min | | | - | | |
| C ex 39 | 0.1 | 2.5 | Running | 700 | 1 sec | 0.03 | 2.4 | Butch | 420 | 2 hr |
| C ex 40 | 0.1 | 3.0 | Butch | 530 | 1 hr | 0.02 | 3.2 | Running | 650 | 0.5 sec |

Table 2-6 (continued-2)

| | Heating 5 | | | | | Working degree in final working |
| | Wire diameter | Working degree | Manner | Heating temp. | Heating period | |
| | mm | | | °C | | |
| C ex 11 | - | | | | | 10.6 |
| C ex 12 | - | | | | | 2.4 |
| C ex 13 | - | | | | | 4.6 |
| C ex 14 | - | | | | | 0.4 |
| C ex 15 | - | | | | | 12.4 |
| C ex 16 | - | | | | | 3.8 |
| C ex 17 | - | | | | | 3.2 |
| C ex 18 | - | | | | | 4.6 |
| C ex 19 | - | | | | | 12.0 |
| C ex 20 | - | | | | | 3.9 |
| C ex 21 | - | | | | | 4.2 |
| C ex 22 | - | | | | | 9.7 |
| C ex 23 | - | | | | | 4.2 |
| C ex 24 | - | | | | | 9.7 |
| C ex 25 | - | | | | | 3.2 |

Table 2-6 (continued-3)

| | Wire diameter mm | Working degree | Heating 5 | | | Working degree in final working |
|---|---|---|---|---|---|---|
| | | | Manner | Heating temp. °C | Heating period | |
| C ex 26 | 0.04 | 1.8 | Butch | 370 | 30 min | 1.8 |
| C ex 27 | | | | | | 3.6 |
| C ex 28 | | | - | | | 3.7 |
| C ex 29 | 0.1 | 4.2 | Running | 380 | 0.5 sec | 4.2 |
| C ex 30 | | | - | | | 3.7 |
| C ex 31 | | | - | | | 1.4 |
| C ex 32 | 0.06 | 1.0 | Electric current | 380 | 0.5 sec | 1.0 |
| C ex 33 | | | - | | | 4.6 |
| C ex 34 | | | - | | | 2.6 |
| C ex 35 | | | - | | | 2.2 |
| C ex 36 | | | | | | 3.2 |
| C ex 37 | 0.03 | 2.4 | Butch | 300 | 1 hr | 2.4 |
| C ex 38 | | | - | | | 3.5 |
| C ex 39 | | | - | | | 2.4 |
| C ex 40 | | | - | | | 3.2 |

Table 2-7

| | Characteristics | | | | | | | | |
|---|---|---|---|---|---|---|---|---|---|
| | Grain size | <100> area ratio | <111> area ratio | El after heating | TS after heating | EC | service life | Coil formability | Comprehensive evaluation |
| | μm | % | % | % | MPa | %IACS | | | |
| Ex 11 | 0.1 | 38 | 50 | 12 | 380 | 100 | A | C | B |
| Ex 12 | 1.0 | 75 | 16 | 22 | 365 | 100 | B | A | A |
| Ex 13 | 0.2 | 55 | 30 | 17 | 380 | 100 | A | B | A |
| Ex 14 | 3.0 | 65 | 16 | 22 | 382 | 99 | A | A | A |
| Ex 15 | 0.1 | 32 | 40 | 13 | 381 | 98 | A | C | B |

(continued)

| | | Characteristics | | | | | | | |
|---|---|---|---|---|---|---|---|---|---|
| | Grain size | <100> area ratio | <111> area ratio | El after heating | TS after heating | EC | service life | Coil formability | Comprehensive evaluation |
| | μm | % | % | % | MPa | %IACS | | | |
| Ex 16 | 0.5 | 45 | 30 | 14 | 381 | 98 | A | C | B |
| Ex 17 | 1.5 | 57 | 11 | 17 | 392 | 94 | A | B | A |
| Ex 18 | 6.0 | 45 | 30 | 12 | 390 | 95 | A | C | B |
| Ex 19 | 1.0 | 77 | 11 | 23 | 370 | 95 | B | A | A |
| Ex 20 | 9.0 | 45 | 26 | 11 | 415 | 91 | A | C | B |
| Ex 21 | 2.0 | 55 | 16 | 18 | 412 | 90 | A | B | A |
| Ex 22 | 0.2 | 41 | 32 | 12 | 413 | 90 | A | C | B |
| Ex 23 | 1.0 | 45 | 27 | 13 | 424 | 88 | A | C | B |
| Ex 24 | 0.3 | 65 | 9 | 23 | 432 | 88 | A | A | A |
| Ex 25 | 7.0 | 67 | 7 | 13 | 424 | 88 | A | C | B |
| Ex 26 | 0.3 | 56 | 11 | 18 | 371 | 90 | B | B | B |
| Ex 27 | 0.1 | 41 | 42 | 12 | 366 | 90 | B | C | C |
| Ex 28 | 0.4 | 62 | 6 | 24 | 378 | 75 | B | A | A |
| Ex 29 | 0.1 | 38 | 41 | 12 | 371 | 75 | B | C | C |
| Ex 30 | 0.6 | 76 | 12 | 23 | 352 | 91 | C | A | B |
| Ex 31 | 0.5 | 62 | 15 | 23 | 368 | 77 | B | A | A |
| Ex 32 | 1.0 | 48 | 22 | 14 | 369 | 89 | B | C | B |
| Ex 33 | 0.3 | 55 | 13 | 18 | 371 | 80 | B | B | B |
| Ex 34 | 0.5 | 47 | 26 | 14 | 368 | 98 | B | C | C |
| Ex 35 | 0.2 | 48 | 27 | 15 | 366 | 95 | B | C | C |

(continued)

| | | Characteristics | | | | | | | |
|---|---|---|---|---|---|---|---|---|---|
| | Grain size | <100> area ratio | <111> area ratio | El after heating | TS after heating | EC | service life | Coil formability | Comprehensive evaluation |
| | μm | % | % | % | MPa | %IACS | | | |
| Ex 36 | 0.3 | 50 | 33 | 12 | 373 | 93 | B | C | C |
| Ex 37 | 0.5 | 70 | 17 | 24 | 379 | 83 | B | A | A |
| Ex 38 | 0.1 | 38 | 42 | 15 | 371 | 95 | B | C | C |
| Ex 39 | 0.3 | 41 | 30 | 12 | 372 | 90 | B | C | C |
| Ex 40 | 0.3 | 47 | 31 | 13 | 376 | 98 | B | C | C |
| Ex 41 | 1.0 | 55 | 13 | 18 | 376 | 90 | B | B | B |
| Ex 42 | 0.8 | 53 | 15 | 19 | 376 | 89 | B | B | B |
| Ex 43 | 2.0 | 35 | 30 | 11 | 379 | 79 | B | C | C |

Table 2-8

| | | Characteristics | | | | | | | |
|---|---|---|---|---|---|---|---|---|---|
| | Grain size | <100> area ratio | <111> area ratio | El after heating | TS after heating | EC | Coil service life | Coil formability | Comprehensive evaluation |
| | μm | % | % | % | MPa | %IACS | | | |
| Ex 44 | 0.5 | 37 | 26 | 12 | 398 | 90 | A | C | B |
| Ex 45 | 1.0 | 42 | 30 | 13 | 398 | 90 | A | C | B |
| Ex 46 | 7.0 | 55 | 25 | 12 | 402 | 83 | A | C | B |
| Ex 47 | 1.2 | 67 | 16 | 23 | 400 | 83 | A | A | A |
| Ex 48 | 2.0 | 77 | 10 | 23 | 378 | 95 | B | A | A |
| Ex 49 | 0.6 | 52 | 17 | 18 | 402 | 88 | A | B | A |
| Ex 50 | 0.4 | 57 | 17 | 17 | 397 | 87 | A | B | A |
| Ex 51 | 0.4 | 43 | 28 | 13 | 423 | 82 | A | C | B |

(continued)

| | | Characteristics | | | | | | | |
|---|---|---|---|---|---|---|---|---|---|
| | Grain size | <100> area ratio | <111> area ratio | El after heating | TS after heating | EC | Coil service life | Coil formability | Comprehensive evaluation |
| | μm | % | % | % | MPa | %IACS | | | |
| Ex 52 | 0.1 | 42 | 30 | 13 | 413 | 87 | A | C | B |
| Ex 53 | 0.7 | 67 | 13 | 25 | 425 | 82 | A | A | A |
| Ex 54 | 1.8 | 58 | 10 | 19 | 422 | 78 | A | B | A |
| Ex 55 | 0.2 | 40 | 32 | 12 | 419 | 88 | A | C | B |
| Ex 56 | 0.1 | 35 | 30 | 12 | 421 | 85 | A | C | B |
| Ex 57 | 0.3 | 49 | 32 | 13 | 423 | 80 | A | C | B |
| Ex 58 | 2.0 | 62 | 18 | 21 | 435 | 86 | A | A | A |
| Ex 59 | 1.0 | 45 | 25 | 13 | 425 | 80 | A | C | B |
| Ex 60 | 0.5 | 47 | 25 | 14 | 438 | 75 | A | C | B |
| | μm | % | % | % | MPa | %IACS | | | |
| Ex 61 | 1.0 | 60 | 18 | 18 | 386 | 90 | A | B | A |
| Ex 62 | 0.1 | 49 | 25 | 12 | 378 | 82 | B | C | c |
| Ex 63 | 0.3 | 43 | 33 | 13 | 372 | 83 | B | C | B |
| Ex 64 | 0.5 | 37 | 31 | 14 | 396 | 93 | A | C | B |
| Ex 65 | 0.1 | 48 | 35 | 12 | 401 | 94 | A | C | B |
| Ex 66 | 0.6 | 66 | 18 | 22 | 415 | 90 | A | A | A |
| Ex 67 | 1.0 | 43 | 30 | 14 | 369 | 87 | B | C | C |
| Ex 68 | 0.1 | 39 | 50 | 12 | 397 | 86 | A | C | B |
| Ex 69 | 2.0 | 67 | 28 | 22 | 382 | 90 | A | A | A |
| Ex 70 | 3.0 | 55 | 30 | 17 | 386 | 85 | A | B | A |

(continued)

| μm | % | % | % | MPa | %IACS | | | | |
|---|---|---|---|---|---|---|---|---|---|
| Ex 71 | 3.0 | 77 | 18 | 22 | 355 | 80 | C | A | B |
| Ex 72 | 2.2 | 56 | 35 | 17 | 415 | 88 | A | B | A |
| Ex 73 | 0.1 | 35 | 55 | 11 | 378 | 87 | B | C | C |
| Ex 74 | 1.5 | 68 | 25 | 23 | 392 | 92 | A | A | A |

Table 2-9

| | | Characteristics | | | | | | | |
|---|---|---|---|---|---|---|---|---|---|
| | Grain size | <100> area ratio | <111> area ratio | E1 after heating | TS after heating | EC | Coil service life | Coil formability | Comprehensive evaluation |
| | μm | % | % | % | MPa | %IACS | | | |
| C ex 11 | 0.1 | <u>21</u> | 71 | <u>7</u> | 351 | 99 | C | D | D |
| C ex 12 | 0.3 | <u>23</u> | 65 | <u>7</u> | 352 | 96 | C | D | D |
| C ex 13 | 7.0 | <u>21</u> | 57 | <u>7</u> | <u>331</u> | 95 | D | D | D |
| C ex 14 | 1.2 | <u>17</u> | 63 | <u>8</u> | <u>330</u> | 96 | D | D | D |
| C ex 15 | 0.1 | <u>19</u> | 71 | <u>5</u> | 357 | 91 | C | D | D |
| C ex 16 | 2.0 | <u>22</u> | 66 | <u>3</u> | <u>331</u> | 90 | D | D | D |
| C ex 17 | 1.0 | <u>19</u> | 69 | <u>5</u> | 352 | 91 | C | D | D |
| C ex 18 | 10.0 | <u>21</u> | 69 | <u>6</u> | <u>345</u> | 90 | D | D | D |
| C ex 19 | 0.2 | <u>22</u> | 66 | <u>8</u> | 354 | 84 | C | D | D |
| C ex 20 | 0.7 | <u>22</u> | 66 | <u>7</u> | 351 | 90 | C | D | D |

(continued)

| | | Characteristics | | | | | | | |
|---|---|---|---|---|---|---|---|---|---|
| | | Grain size | <100> area ratio | <111> area ratio | E1 after heating | TS after heating | EC | Coil service life | Coil formability | Comprehensive evaluation |
| | | μm | % | % | % | MPa | %IACS | | | |
| C ex 21 | 0.4 | 28 | 61 | 7 | 335 | 98 | D | D | D |
| C ex 22 | 1.0 | 26 | 62 | 9 | 353 | 93 | C | D | D |
| C ex 23 | 10.0 | 26 | 62 | 6 | 351 | 95 | C | D | D |
| C ex 24 | 0.1 | 12 | 76 | 7 | 351 | 98 | C | D | D |
| C ex 25 | 2.0 | 25 | 68 | 6 | 271 | 89 | D | D | D |
| C ex 26 | 1.2 | 65 | 25 | 21 | 330 | 100 | D | A | D |
| C ex 27 | 0.1 | 41 | 50 | 12 | 329 | 96 | D | C | D |
| C ex 28 | 0.1 | 35 | 49 | 11 | 375 | 67 | B | C | D |
| C ex 29 | 0.1 | 25 | 68 | 7 | 325 | 95 | D | D | D |
| C ex 30 | 0.2 | 41 | 43 | 11 | 368 | 67 | B | C | D |
| C ex 31 | 0.5 | 28 | 61 | 8 | 325 | 96 | D | D | D |
| C ex 32 | 2.0 | 74 | 20 | 22 | 328 | 98 | D | A | D |
| C ex 33 | 0.1 | 22 | 70 | 8 | 385 | 68 | A | D | D |
| C ex 34 | 2.2 | 57 | 31 | 17 | 324 | 99 | D | B | D |

(continued)

| | | Characteristics | | | | | | | |
|---|---|---|---|---|---|---|---|---|---|
| | Grain size | <100> area ratio | <111> area ratio | E1 after heating | TS after heating | EC | Coil service life | Coil formability | Comprehensive evaluation |
| | μm | % | % | % | MPa | %IACS | | | |
| C ex 35 | 3.2 | 58 | 29 | 18 | 315 | 99 | D | B | D |
| C ex 36 | 0.1 | 42 | 49 | 13 | 319 | 67 | D | C | D |
| C ex 37 | 0.1 | 28 | 62 | 8 | 373 | 66 | B | D | D |
| C ex 38 | 0.1 | 42 | 45 | 12 | 328 | 98 | D | C | D |
| C ex 39 | 1.8 | 55 | 39 | 16 | 422 | 60 | A | B | D |
| C ex 40 | 0.1 | 41 | 51 | 11 | 432 | 60 | A | C | D |

Also in the case of a copper alloy round wire in which (1) Ag and/or (2) at least one element selected from the group consisting of Sn, Mg, Zn, In, Ni, Co, Zr, and Cr is added to Cu, similarly to the case of the Cu-Ag alloy, when the <100> texture amount was controlled to be the area ratio of grains having a predetermined <100> orientation, characteristics were exhibited, in which the elongation and the physical strength were high and in which coil characteristics were also excellent. Among them, a round wire of a Cu-Ag-based alloy is higher in physical strength as compared with other copper alloy round wires. For example, as compared with Examples 17 and 26 in which almost the same working and heating were performed, it was found that Example 17 was excellent in characteristics and the Cu-Ag alloy round wire was particularly suitable for a magnet wire.

The examples and comparative examples of rectangular wires are presented in Tables 3-1 to 3-3.

In Tables 3-1 to 3-2, the size after the rectangular wire-working was represented as the thickness t (mm) × the width w (mm). Of "Heating 2, Heating 3, or Heating 4," the rectangular wire-working was performed by working presented in the columns of "Heating 3, Heating 4, or Heating 5" on the round wire having a wire diameter φ (mm) after the finally-performed intermediate heating x (x-th, x = final). The heating presented in the columns of "Heating 3, Heating 4, or Heating 5" which is finally performed is the final heating (final-annealing).

Table 3-1

| | Composition* | | | | | | | | | Ingot diameter |
| | Ag | Mg | Sn | In | Zn | Ni | Cr | Zr | Co | |
| | mass% | mass% | mass% | mass% | mass% | mass% | mass% | mass% | mass% | mm |
|---|---|---|---|---|---|---|---|---|---|---|
| Ex 75 | 0.1 | - | - | - | - | - | - | - | - | 10 |
| Ex 76 | 0.5 | - | - | - | - | - | - | - | - | 22 |
| Ex 77 | 1 | - | - | - | - | - | - | - | - | 16 |
| Ex 78 | 2 | - | - | - | - | - | - | - | - | 10 |
| Ex 79 | 4 | - | - | - | - | - | - | - | - | 10 |
| Ex 80 | - | 0.3 | - | - | - | - | - | - | - | 10 |
| Ex 81 | - | - | 0.3 | - | - | - | - | - | - | 12 |
| Ex 82 | - | - | - | - | - | 0.1 | - | - | - | 10 |
| Ex 83 | - | - | - | - | - | - | 0.1 | - | - | 10 |
| Ex 84 | - | - | - | - | - | - | - | 0.3 | - | 22 |
| Ex 85 | - | - | - | - | - | - | - | - | 0.1 | 10 |
| Ex 86 | 0.5 | 0.1 | - | - | - | - | - | - | - | 10 |
| Ex 87 | 1 | 0.1 | - | - | - | - | - | - | - | 10 |
| Ex 88 | 3 | 0.05 | - | - | - | - | - | - | - | 16 |
| Ex 89 | - | 0.15 | - | - | 0.2 | - | - | - | - | 22 |
| Ex 90 | 1 | - | - | 0.1 | - | - | - | - | - | 8 |
| Ex 91 | 2 | - | 0.1 | 0.1 | - | - | 0.05 | - | - | 8 |
| C ex 41 | 1 | - | - | - | - | - | - | - | - | 10 |
| C ex 42 | 3 | - | - | - | - | - | - | - | - | 20 |
| C ex 43 | - | 0.1 | - | - | - | - | - | - | - | 10 |
| C ex 44 | - | - | - | 0.1 | - | - | - | - | - | 10 |
| C ex 45 | - | - | - | - | 0.1 | - | - | - | - | 8 |
| C ex 46 | - | - | - | - | - | 0.1 | - | - | - | 10 |
| C ex 47 | - | - | - | - | - | - | 0.1 | - | - | 8 |
| C ex 48 | - | - | - | - | - | - | - | - | 0.1 | 8 |
| C ex 49 | 0.05 | - | - | - | - | - | - | - | - | 10 |
| C ex 50 | - | 0.4 | - | - | - | - | - | - | - | 10 |
| C ex 51 | - | - | - | 0.04 | - | - | - | - | - | 20 |
| C ex 52 | - | - | - | - | - | 0.6 | - | - | - | 10 |
| C ex 53 | - | - | - | - | - | - | 0.03 | - | - | 20 |
| C ex 54 | 3 | 0.1 | 0.5 | - | - | - | - | - | - | 15 |

Note: * The balance was Cu and unavoidable impurities, and "-" means not added.
"Ex" means Example according to this invention, and "C ex" means Comparative example.   The same is applied to hereinafter.

Table 3-1 (continued)

| | Heating 1 | | | | | Heating 2 | | | | |
|---|---|---|---|---|---|---|---|---|---|---|
| | Φ | Working degree | Manner | Heating temp. | Heating period | Φ or t x w | Working degree | Manner | Heating temp. | Heating period |
| | mm | | | °C | | mm | | | °C | |
| Ex 75 | 2.6 | 2.7 | Butch | 420 | 1 hr | 0.7 | 2.6 | Butch | 430 | 1 hr |
| Ex 76 | 8 | 2.0 | Butch | 430 | 30 min | 2.6 | 2.2 | Butch | 420 | 30 min |
| Ex 77 | 2.6 | 3.6 | Butch | 430 | 1 hr | 0.4 | 3.7 | Butch | 440 | 1 hr |
| Ex 78 | 2 | 3.2 | Butch | 520 | 30 min | 0.4 | 3.2 | Butch | 800 | 30 min |
| Ex 79 | 2.6 | 2.7 | Running | 700 | 0.5 sec | 0.9 | 2.1 | Running | 700 | 0.5 sec |
| Ex 80 | 2.6 | 2.7 | Running | 500 | 1 sec | 0.6 | 2.9 | Running | 500 | 1 sec |
| Ex 81 | 2.6 | 3.1 | Running | 420 | 1 sec | 0.6 | 2.9 | Running | 420 | 1 sec |
| Ex 82 | 2 | 3.2 | Running | 500 | 1 sec | 0.6 | 2.4 | Butch | 420 | 2 hr |
| Ex 83 | 2 | 3.2 | Electric current | 480 | 1 sec | 0.5 | 2.8 | Butch | 400 | 1 hr |
| Ex 84 | 8 | 2.0 | Butch | 400 | 1 hr | 2.6 | 2.2 | Running | 530 | 4 sec |
| Ex 85 | 2.6 | 2.7 | Electric current | 520 | 0.5 sec | 0.5 | 3.3 | Running | 530 | 0.5 sec |
| Ex 86 | 2.6 | 2.7 | Running | 530 | 2 sec | 0.6 | 2.9 | Running | 570 | 2 sec |
| Ex 87 | 2 | 3.2 | Butch | 500 | 30 min | 0.4 | 3.2 | Butch | 480 | 30 min |
| Ex 88 | 2.6 | 3.6 | Running | 610 | 1 sec | 0.7 | 2.6 | Running | 610 | 1 sec |
| Ex 89 | 8 | 2.0 | Butch | 400 | 30 min | 2.6 | 2.2 | Butch | 420 | 30 min |
| Ex 90 | 2 | 2.8 | Electric current | 650 | 0.5 sec | 0.6 | 2.4 | Electric current | 650 | 0.5 sec |
| Ex 91 | 2.6 | 2.2 | Running | 650 | 2 sec | 1.5 | 1.1 | Butch | 530 | 30 min |
| C ex 41 | 1.2 | 4.2 | Running | 550 | 1 sec | 0.15 | 4.2 | Running | 550 | 1 sec |
| C ex 42 | 2.6 | 4.1 | Butch | 550 | 1 hr | 1 | 1.9 | Running | 680 | 1 sec |
| C ex 43 | 2 | 3.2 | Running | 550 | 1 sec | 0.5 | 2.8 | Running | 520 | 1 sec |
| C ex 44 | 2.6 | 2.7 | Running | 520 | 1 sec | 0.7 | 2.6 | Running | 250 | 1 sec |
| C ex 45 | 1.5 | 3.3 | Butch | 400 | 2 hr | 1 | 0.8 | Butch | 420 | 2 hr |
| C ex 46 | 6 | 1.0 | Butch | 430 | 30 min | 0.02 x 1 | 9.7 | Butch | 300 | 30 min |
| C ex 47 | 1.5 | 3.3 | Electric current | 600 | 2 sec | 0.45 | 2.4 | Butch | 400 | 30 min |
| C ex 48 | 1.5 | 3.3 | Running | 250 | 1 sec | 0.5 | 2.2 | Butch | 400 | 1 hr |
| C ex 49 | 2 | 3.2 | Butch | 480 | 1 hr | 0.5 | 2.8 | Running | 570 | 2 sec |
| C ex 50 | 2.6 | 2.7 | Running | 480 | 1 sec | 0.7 | 2.6 | Butch | 400 | 1 hr |
| C ex 51 | 1 | 6.0 | Running | 480 | 1 sec | 0.5 | 1.4 | Electric current | 500 | 0.3 sec |
| C ex 52 | 5 | 1.4 | Butch | 430 | 30 min | 1.3 | 2.7 | Running | 500 | 0.5 sec |
| C ex 53 | 8 | 1.8 | Running | 480 | 1 sec | 2 | 2.8 | Electric current | 480 | 1 sec |
| C ex 54 | 2.2 | 3.8 | Running | 700 | 1 sec | 0.35 | 3.7 | Butch | 530 | 1 hr |

Table 3-2

| | Heating 3 | | | | | Heating 4 | | | | |
|---|---|---|---|---|---|---|---|---|---|---|
| | Φ or t x w mm | Working degree | Manner | Temp.* °C | Period* | Φ or t x w mm | Working degree | Manner | Temp.* °C | Period* |
| Ex 75 | 0.1 x 1.8 | 3.2 | Butch | 370 | 1 hr | - | | | | |
| Ex 76 | 0.5 | 3.3 | Butch | 430 | 30 min | 0.2 | 1.8 | Butch | 430 | 30 min |
| Ex 77 | 0.1 | 2.8 | Butch | 440 | 1 hr | 0.04 x 0.07 | 0.8 | Butch | 390 | 1 hr |
| Ex 78 | 0.06 x 1 | 3.2 | Butch | 420 | 30 min | - | | | | |
| Ex 79 | 0.3 | 2.2 | Butch | 550 | 1 hr | 0.08 x 0.35 | 1.8 | Running | 650 | 0.5 sec |
| Ex 80 | 0.06 x 2 | 3.8 | Running | 450 | 1 sec | - | | | | |
| Ex 81 | 0.2 | 2.2 | Running | 420 | 1 sec | 0.04 x 0.15 | 1.8 | Running | 420 | 1 sec |
| Ex 82 | 0.07 x 1 | 3.5 | Butch | 300 | 2 hr | - | | | | |
| Ex 83 | 0.05 x 1 | 3.6 | Running | 400 | 1 sec | - | | | | |
| Ex 84 | 1 | 1.9 | Butch | 420 | 1 hr | 0.2 | 3.2 | Running | 520 | 4 sec |
| Ex 85 | 0.15 | 2.4 | Electric current | 540 | 0.5 sec | 0.03 x 0.1 | 2.4 | Electric current | 400 | 0.5 sec |
| Ex 86 | 0.06 x 1.2 | 3.8 | Running | 500 | 2 sec | - | | | | |
| Ex 87 | 0.15 | 2.0 | Butch | 520 | 30 min | 0.03 x 0.15 | 2.4 | Butch | 400 | 30 min |
| Ex 88 | 0.08 x 0.8 | 3.5 | Running | 610 | 1 sec | - | | | | |
| Ex 89 | 0.6 | 2.9 | Electric current | 480 | 0.3 sec | 0.07 x 0.8 | 3.5 | Butch | 320 | 30 min |
| Ex 90 | 0.08 x 0.2 | 3.2 | Electric current | 550 | 0.5 sec | - | | | | |
| Ex 91 | 0.6 | 1.8 | Electric current | 660 | 0.2 sec | 0.1 x 0.15 | 2.8 | Electric current | 550 | 2 sec |
| C ex 41 | 0.03 x 0.15 | 2.4 | Running | 450 | 1 sec | - | | | | |
| C ex 42 | 0.5 | 1.4 | Running | 680 | 1 sec | 0.06 x 0.4 | 3.2 | Butch | 420 | 1 hr |
| C ex 43 | 0.03 x 0.1 | 4.6 | Electric current | 400 | 2 sec | - | | | | |
| C ex 44 | 0.07 x 0.2 | 3.9 | Electric current | 400 | 1 sec | - | | | | |
| C ex 45 | 0.3 | 2.4 | Electric current | 530 | 0.6 sec | 0.03 x 0.1 | 4.2 | Butch | 300 | 30 min |
| C ex 46 | - | | | | | - | | | | |
| C ex 47 | 0.03 x 0.8 | 4.2 | Electric current | 400 | 0.2 sec | - | | | | |
| C ex 48 | 0.06 x 1.5 | 3.2 | Running | 400 | 1 sec | - | | | | |
| C ex 49 | 0.2 | 1.8 | Butch | 480 | 1 hr | 0.15 | 0.6 | Electric current | 570 | 1 sec |
| C ex 50 | 0.08 x 0.45 | 3.7 | Running | 480 | 1 sec | - | | | | |
| C ex 51 | 0.15 | 2.4 | Butch | 430 | 30 min | 0.05 x 0.4 | 1.4 | Running | 380 | 0.5 sec |
| C ex 52 | 0.1 x 1.5 | 4.6 | Running | 480 | 1 sec | - | | | | |
| C ex 53 | 0.4 | 3.2 | Butch | 430 | 1 hr | 0.08 x 0.35 | 2.6 | Butch | 300 | 1 hr |
| C ex 54 | 0.15 | 1.7 | Running | 700 | 1 sec | 0.03 x 0.1 | 2.4 | Butch | 420 | 2 hr |

Note: * Temp. and Period represent Heating temp. and Heating period, respectively.   The same is applied to hereinafter.

Table 3-2 (continued)

| | t x w mm | Heating 5 Working degree | Manner | Temp. °C | Period | Working degree in final working |
|---|---|---|---|---|---|---|
| Ex 75 | | | - | | | 3.2 |
| Ex 76 | 0.02 x 0.3 | 3.2 | Butch | 370 | 30 min | 3.2 |
| Ex 77 | | | - | | | 0.8 |
| Ex 78 | | | - | | | 3.2 |
| Ex 79 | | | - | | | 1.8 |
| Ex 80 | | | - | | | 3.8 |
| Ex 81 | | | - | | | 1.8 |
| Ex 82 | | | - | | | 3.5 |
| Ex 83 | | | - | | | 3.6 |
| Ex 84 | 0.05 x 0.2 | 2.2 | Running | 450 | 4 sec | 2.2 |
| Ex 85 | | | - | | | 2.4 |
| Ex 86 | | | - | | | 3.8 |
| Ex 87 | | | - | | | 2.4 |
| Ex 88 | | | - | | | 3.5 |
| Ex 89 | | | - | | | 3.5 |
| Ex 90 | | | - | | | 3.2 |
| Ex 91 | | | - | | | 2.8 |
| C ex 41 | | | - | | | 2.4 |
| C ex 42 | | | - | | | 3.2 |
| C ex 43 | | | - | | | 4.6 |
| C ex 44 | | | - | | | 3.9 |
| C ex 45 | | | - | | | 4.2 |
| C ex 46 | | | - | | | 9.7 |
| C ex 47 | | | - | | | 4.2 |
| C ex 48 | | | - | | | 3.2 |
| C ex 49 | 0.04 x 0.2 | 1.8 | Butch | 370 | 30 min | 1.8 |
| C ex 50 | | | - | | | 3.7 |
| C ex 51 | | | - | | | 1.4 |
| C ex 52 | | | - | | | 4.6 |
| C ex 53 | | | - | | | 2.6 |
| C ex 54 | | | - | | | 2.4 |

Table 3-3

| | Characteristics | | | | | | | | |
|---|---|---|---|---|---|---|---|---|---|
| | Grain size | <100> area ratio | <111> area ratio | El after heating | TS after heating | EC | Coil service life | Coil formability | Comprehensive evaluation |
| | μm | % | % | % | MPa | %IACS | | | |
| Ex 75 | 0.1 | 36 | 55 | 11 | 383 | 100 | A | C | B |
| Ex 76 | 0.3 | 43 | 42 | 13 | 383 | 98 | A | C | B |
| Ex 77 | 1.2 | 76 | 15 | 24 | 372 | 94 | B | A | A |
| Ex 78 | 0.1 | 42 | 38 | 12 | 415 | 91 | A | C | B |
| Ex 79 | 1.1 | 61 | 25 | 22 | 428 | 88 | A | A | A |
| Ex 80 | 0.1 | 37 | 45 | 11 | 375 | 75 | B | C | C |
| Ex 81 | 0.3 | 61 | 25 | 22 | 371 | 77 | B | A | A |

(continued)

| | | Characteristics | | | | | | | |
|---|---|---|---|---|---|---|---|---|---|
| | Grain size | <100> area ratio | <111> area ratio | El after heating | TS after heating | EC | Coil service life | Coil formability | Comprehensive evaluation |
| | μm | % | % | % | MPa | %IACS | | | |
| Ex 82 | 0.1 | 50 | 43 | 12 | 383 | 93 | B | C | C |
| Ex 83 | 0.1 | 36 | 45 | 15 | 376 | 95 | B | C | C |
| Ex 84 | 1.2 | 51 | 28 | 18 | 379 | 90 | B | B | B |
| Ex 85 | 0.7 | 53 | 35 | 17 | 376 | 89 | B | B | B |
| Ex 86 | 0.6 | 38 | 45 | 11 | 400 | 90 | A | C | B |
| Ex 87 | 0.4 | 55 | 23 | 18 | 397 | 87 | A | B | A |
| Ex 88 | 0.2 | 42 | 38 | 13 | 420 | 88 | A | C | B |
| Ex 89 | 0.1 | 45 | 39 | 11 | 385 | 82 | B | C | C |
| Ex 90 | 0.2 | 38 | 45 | 14 | 398 | 93 | A | B | A |
| Ex 91 | 1.8 | 52 | 42 | 16 | 412 | 88 | A | B | A |
| C ex 41 | 0.5 | <u>27</u> | 64 | <u>7</u> | 351 | 96 | C | D | D |
| C ex 42 | 1.0 | 21 | 69 | <u>6</u> | 353 | 91 | C | D | D |
| C ex 43 | 12.0 | <u>19</u> | 73 | <u>6</u> | <u>335</u> | 90 | D | D | D |
| C ex 44 | 0.5 | <u>23</u> | 69 | <u>6</u> | <u>349</u> | 90 | C | D | D |
| C ex 45 | 0.3 | <u>27</u> | 63 | <u>8</u> | <u>341</u> | 98 | D | D | D |
| C ex 46 | 1.5 | <u>24</u> | 69 | <u>9</u> | 351 | 93 | C | D | D |
| C ex 47 | 10.0 | <u>22</u> | 72 | <u>6</u> | 356 | 95 | C | D | D |

(continued)

| | | Characteristics | | | | | | | |
|---|---|---|---|---|---|---|---|---|---|
| | Grain size | <100> area ratio | <111> area ratio | El after heating | TS after heating | EC | Coil service life | Coil formability | Comprehensive evaluation |
| | μm | % | % | % | MPa | %IACS | | | |
| C ex 48 | 2.2 | 23 | 67 | 5 | 351 | 89 | D | D | D |
| C ex 49 | 1.1 | 67 | 25 | 22 | 311 | 100 | D | A | D |
| C ex 50 | 0.1 | 33 | 49 | 11 | 375 | 67 | B | C | D |
| C ex 51 | 1.5 | 25 | 63 | 7 | 315 | 96 | D | D | D |
| C ex 52 | 0.1 | 21 | 73 | 8 | 378 | 68 | B | D | D |
| C ex 53 | 2.2 | 51 | 33 | 15 | 331 | 99 | D | B | D |
| C ex 54 | 1.8 | 51 | 40 | 15 | 412 | 60 | A | B | D |

From Tables 3-1 to 3-3, it is found that even in the case of the rectangular wires, the similar results as in the case of the round wires presented in Tables 1-1 to 1-3 and Tables 2-1 to 2-9 were obtained.

The examples and comparative examples regarding the round wires when round wires made of a Cu-2% Ag alloy were prodeced up to a final wire diameter of $\phi$0.05 mm to 0.2 mm, are presented in Tables 4-1 and 4-2.

Table 4-1

| | Composition* | Ingot diameter | Heating 1 | | | | |
|---|---|---|---|---|---|---|---|
| | Ag | | Wire diameter | Working degree | Manner | Heating temp. | Heating period |
| | mass% | mm | mm | | | °C | |
| Ex 94 | 2 | 10 | 2.6 | 2.7 | Running | 650 | 1 sec |
| Ex 95 | 2 | 10 | 1.4 | 3.9 | Running | 650 | 1 sec |
| C ex 55 | 2 | 10 | 3 | 2.4 | Running | 650 | 1 sec |
| C ex 56 | 2 | 10 | 2.2 | 3.0 | Running | 650 | 1 sec |
| C ex 57 | 2 | 10 | 1.5 | 3.8 | Running | 650 | 1 sec |
| C ex 58 | 2 | 10 | 0.75 | 5.2 | Running | 650 | 1 sec |

Note: * The balance was Cu and unavoidable impurities, and "-" means not added.
"Ex" means Example according to this invention, and "C ex" means Comparative example.   The same is applied to hereinafter.

Table 4-1 (continued)

| | Heating 2 | | | | | Heating 3 | | | | |
|---|---|---|---|---|---|---|---|---|---|---|
| | Wire diameter mm | Working degree | Manner | Heating temp. °C | Heating period | Wire diameter mm | Working degree | Manner | Heating temp. °C | Heating period |
| Ex 94 | 0.4 | 3.7 | Running | 650 | 1 sec | 0.1 | 2.8 | Running | 550 | 1 sec |
| Ex 95 | 0.2 | 3.9 | Running | 650 | 1 sec | 0.05 | 2.8 | Running | 550 | 1 sec |
| C ex 55 | 0.2 | 5.4 | Running | 550 | 1 sec | | | - | | |
| C ex 56 | 0.15 | 5.4 | Running | 550 | 1 sec | | | - | | |
| C ex 57 | 0.1 | 5.4 | Running | 550 | 1 sec | | | - | | |
| C ex 58 | 0.05 | 5.4 | Running | 550 | 1 sec | | | - | | |

Table 4-2

| | | Characteristics | | | | | | | |
|---|---|---|---|---|---|---|---|---|---|
| | Grain size | <100> area ratio | <111> area ratio | El after heating | TS after heating | EC | Coil service life | Coil formability | Comprehensive evaluation |
| | μm | % | % | % | MPa | %IACS | | | |
| Ex 94 | 0.60 | 57 | 13 | 16 | 405 | 93 | A | B | A |
| Ex 95 | 0.60 | 55 | 22 | 17 | 410 | 92 | A | B | A |
| C ex 55 | 0.20 | <u>22</u> | 62 | <u>9</u> | 369 | 91 | B | C | D |
| C ex 56 | 0.15 | <u>23</u> | 61 | <u>8</u> | 372 | 92 | B | C | D |
| C ex 57 | 0.15 | <u>22</u> | 60 | <u>7</u> | 375 | 92 | B | D | D |
| C ex 58 | 0.10 | 21 | 61 | <u>7</u> | 375 | 92 | B | D | D |

The bending test was performed in such a manner that the radius of bending radius R was fixed to 1 mm such that the bending strain became constant in any of wire diameters. With respect to the comparative examples, even in copper alloy round wires having any of wire diameters, the examples exhibited characteristics, in which both the elongation and the physical strength were excellent, and in which coil characteristics were also excellent. In particular, in the case of a copper alloy round wire having a fine wire diameter, it is found that a difference in performance between the examples and the comparative examples is noticeable, and that the present invention is extremely effective for an extra-fine wire.

Also in the case of the rectangular wires, the similar results as in the case of the round wires are obtained.

The change in characteristics when the working rate per pass in each cold-working step (intermediate cold-working and finish cold-working) using a Cu-2% Ag alloy round wire is changed is presented in Tables 5-1 and 5-2.

Table 5-1

| | Composition* | | Heating 1 | | | | | |
| | Ag | Ingot diameter | Wire diameter | Working degree | Working rate per pass | Manner | Heating temp. | Heating period |
| | mass% | mm | mm | | % | | °C | |
| Ex 96 | 2 | 10 | 2.6 | 2.7 | 10 | Running | 650 | 1 sec |
| Ex 97 | 2 | 10 | 2.6 | 2.7 | 4 | Running | 650 | 1 sec |
| Ex 98 | 2 | 10 | 2.6 | 2.7 | 5 | Running | 650 | 1 sec |
| Ex 99 | 2 | 10 | 2.6 | 2.7 | 17 | Running | 650 | 1 sec |
| Ex 100 | 2 | 10 | 2.6 | 2.7 | 15 | Running | 650 | 1 sec |
| Ex 101 | 2 | 10 | 2.6 | 2.7 | 17 | Running | 650 | 1 sec |
| Ex 102 | 2 | 10 | 2.6 | 2.7 | 20 | Running | 650 | 1 sec |
| Ex 103 | 2 | 10 | 2.6 | 2.7 | 19 | Running | 650 | 1 sec |
| Ex 104 | 2 | 10 | 2.6 | 2.7 | 10 | Running | 650 | 1 sec |
| Ex 105 | 2 | 10 | 2.6 | 2.7 | 10 | Running | 650 | 1 sec |
| C ex 59 | 2 | 10 | 2.6 | 2.7 | 10 | Running | 650 | 1 sec |
| C ex 60 | 2 | 10 | 2.6 | 2.7 | 17 | Running | 650 | 1 sec |
| C ex 61 | 2 | 10 | 2.6 | 2.7 | 20 | Running | 650 | 1 sec |
| C ex 62 | 2 | 10 | 2.6 | 2.7 | 5 | Running | 650 | 1 sec |

Note: * The balance was Cu and unavoidable impurities, and "-" means not added.
"Ex" means Example according to this invention, and "C ex" means Comparative example. The same is applied to hereinafter.

Table 5-1 (continued)

| | Heating 2 | | | | | | Heating 3 | | | | | |
|---|---|---|---|---|---|---|---|---|---|---|---|---|
| | Wire diameter | Working degree | Working rate per pass | Manner | Heating temp. | Heating period | Wire diameter | Working degree | Working rate per pass | Manner | Heating temp. | Heating period |
| | mm | | % | | °C | | mm | | % | | °C | |
| Ex 96 | 0.4 | 3.7 | 7 | Running | 650 | 1 sec | 0.1 | 2.8 | 10 | Running | 550 | 1 sec |
| Ex 97 | 0.4 | 3.7 | 11 | Running | 650 | 1 sec | 0.1 | 2.8 | 11 | Running | 550 | 1 sec |
| Ex 98 | 0.4 | 3.7 | 10 | Running | 650 | 1 sec | 0.1 | 2.8 | 4 | Running | 550 | 1 sec |
| Ex 99 | 0.4 | 3.7 | 25 | Running | 650 | 1 sec | 0.1 | 2.8 | 7 | Running | 550 | 1 sec |
| Ex 100 | 0.4 | 3.7 | 27 | Running | 650 | 1 sec | 0.1 | 2.8 | 10 | Running | 550 | 1 sec |
| Ex 101 | 0.4 | 3.7 | 10 | Running | 650 | 1 sec | 0.1 | 2.8 | 5 | Running | 550 | 1 sec |
| Ex 102 | 0.4 | 3.7 | 17 | Running | 650 | 1 sec | 0.1 | 2.8 | 25 | Running | 550 | 1 sec |
| Ex 103 | 0.4 | 3.7 | 26 | Running | 650 | 1 sec | 0.1 | 2.8 | 13 | Running | 550 | 1 sec |
| Ex 104 | 0.4 | 3.7 | 10 | Running | 650 | 1 sec | 0.1 | 2.8 | 11 | Running | 550 | 1 sec |
| Ex 105 | 0.4 | 3.7 | 10 | Running | 650 | 1 sec | 0.1 | 2.8 | 11 | Running | 550 | 1 sec |
| C ex 59 | 0.1 | 6.5 | 10 | Running | 650 | 1 sec | | | - | | | |
| C ex 60 | 0.2 | 5.1 | 12 | Running | 650 | 1 sec | 0.1 | 1.4 | 14 | Running | 550 | 1 sec |
| C ex 61 | 0.2 | 5.1 | 20 | Running | 650 | 1 sec | 0.1 | 1.4 | 20 | Running | 550 | 1 sec |
| C ex 62 | 0.1 | 6.5 | 5 | Running | 650 | 1 sec | | | - | | | |

Table 5-2

| | Characteristics | | | | | | | | | |
|---|---|---|---|---|---|---|---|---|---|---|
| | Grain size | <100> area ratio | <111> area ratio | Io(100)/Ii (100) | El after heating | TS after heating | EC | Coil service life | Coil formability | Comprehensive evaluation |
| | μm | % | % | | % | MPa | %IACS | | | |
| Ex 96 | 0.9 | 58 | 20 | 0.77 | 17 | 406 | 92 | AA | B | A |
| Ex 97 | 1.1 | 56 | 19 | 0.59 | 16 | 407 | 93 | AA | B | A |
| Ex 98 | 1.0 | 57 | 13 | 0.75 | 18 | 405 | 92 | AA | B | A |
| Ex 99 | 0.8 | 55 | 22 | 1.25 | 16 | 410 | 93 | A | A | A |
| Ex 100 | 0.7 | 52 | 28 | 1.30 | 17 | 407 | 93 | A | A | A |
| Ex 101 | 0.6 | 55 | 24 | 1.40 | 16 | 405 | 92 | A | A | A |
| Ex 102 | 0.9 | 58 | 20 | 1.15 | 18 | 406 | 94 | B | B | B |
| Ex 103 | 0.8 | 56 | 19 | 1.07 | 19 | 407 | 93 | B | B | B |
| Ex 104 | 0.7 | 55 | 23 | 0.82 | 17 | 407 | 93 | B | B | A |
| Ex 105 | 0.8 | 54 | 20 | 0.91 | 18 | 405 | 92 | B | B | A |
| C ex 59 | 0.5 | 25 | 65 | 0.65 | 4 | 405 | 93 | B | D | D |
| C ex 60 | 0.3 | 21 | 59 | 1.25 | 5 | 403 | 92 | B | D | D |
| C ex 61 | 0.4 | 23 | 58 | 1.10 | 3 | 402 | 93 | B | D | D |
| C ex 62 | 0.7 | 22 | 49 | 0.74 | 8 | 410 | 93 | B | D | D |

In Examples 96 to 105, the wire diameter, the working degree, and the heating conditions before each heating (Heatings 1 to 2 as the intermediate annealing and Heating 3 as the finish-annealing) are the same, but the working rate per pass in each working step is changed. Examples 96 to 105 are copper alloy round wires all satisfying an area ratio of the <100> texture of 30% or more.

In Examples 96 to 98, all of working rates per pass in each step before Heating 1 and Heating 2 as the intermediate cold-working and before Heating 3 as the finish cold-working are within the range of 3% or more but less than 12%, and the texture satisfies Io(100)/Ii(100) < 0.8. These Examples 96 to 98 are more excellent in the service life of the coil, as compared to Examples 99 to 101 in which the texture satisfies Io(100)/Ii(100) > 1.2 and Examples 102 to 105 in which the texture is uniform and satisfies $0.8 \leq$ Io(100)/Ii(100) $\leq 1.2$.

On the other hand, in Examples 99 to 101, the working rate per pass in each step before Heating 1 and Heating 2 as the intermediate cold-working other than the final cold-working step (working step before Heating 3 as the final-annealing) is 12% or more but less than 35%, the working rate in the final cold-working step (working step before Heating 3 as the final-annealing) is 3% or more but less than 12%, and the texture satisfies Io(100)/Ii(100) > 1.2. These Examples 99 to 101 are more excellent in the coil formability, as compared to Examples 96 to 98 in which the texture satisfies Io(100)/Ii(100) < 0.8 and Examples 102 to 105 in which the texture is uniform and satisfies $0.8 \leq$ Io(100)/Ii(100) $\leq 1.2$.

Herein, as understood from the explanation described above, the fact that the texture is uniform means that a difference is not large, in the state of the <100> texture control between the center portion and the outer circumferential portion of the wire. This corresponds to the fact that the degree of control of the texture state is described based on a relative difference, with respect to the case of comparison with the state of Io(100)/Ii(100) < 0.8 in which the <100> texture in the center portion is controlled to further increase or the state of Io(100)/Ii(100) > 1.2 in which the <100> texture in the outer circumferential portion is controlled to further increase.

Contrary to the above, in the copper alloy round wires of Comparative Examples 59 to 62, the working rate per pass was changed so as to change the Io(100)/Ii(100) ratio. However, since the condition of the example that the area ratio of the <100> texture would be 30% or more was not satisfied, characteristics of the elongation and the coil formability were poor.

In this way, it is found that by changing the Io(100)/Ii(100) ratio, a target copper alloy round wire more excellent in coil formability and service life of a coil can be separately produced.

In addition, in each example described above, it was found that in a case where the <100> area ratio is 55% or more and the <111> area ratio is 25% or less, the comprehensive evaluation is 'B' or higher and preferred characteristics are obtained.

Also in the case of the rectangular wires, the similar results as in the case of the round wires are obtained.

**Claims**

1. A copper alloy wire consisting of at least one selected from the group consisting of:

    [1] 0.1 to 4 mass% of Ag; and
    [2] at least one selected from the group consisting of Sn, Mg, Zn, In, Ni, Co, Zr and Cr each at a content of 0.05 to 0.3 mass%,

    with the balance being Cu and unavoidable impurities, wherein the copper alloy wire has a recrystallized texture, an area ratio of grains having <100> orientation is 30% or more of the entire measurement area, wherein the area ratio of the grains having <100> orientation is obtained by an EBSD method in such a manner that the transverse cross-section of a copper alloy wire sample is smoothed to be a measurement surface, the orientation of grains on the measurement surface is measured at a step of 0.02 um in the entire diameter direction of the copper alloy wire sample after the measurement conditions are adjusted with respect to the copper allov wire sample such that a vacuum degree is set to about $10^{-4}$ to $10^{-5}$ Pa, and an acceleration voltage is set to 20 to 30 V, and a reliability index, that is. a CI value, as calculated with OIM software is set to 0.2 or more, and then the area ratio of the grain having <100> orientation with respect to the entire measurement area is calculated based on the measurement result: and wherein the copper alloy wire has a tensile strength of 350 MPa or more, a semi-softened state with an elongation of 10% to 30%, and a wire diameter or wire thickness of 0.1 mm or less and 0.01 mm or more.

2. The copper alloy wire according to claim 1, wherein the area ratio of the grains having <100> orientation is 50% or more of the entire measurement area.

3. The copper alloy wire according to claim 1 or 2, wherein the area ratio of the grains having <100> orientation is less than 75% of the entire measurement area.

4. The copper alloy wire according to any one of claims 1 to 3, wherein the average grain size of the matrix is 0.2 $\mu$m or more but 5 $\mu$m or less.

5. The copper alloy wire according to any one of claims 1 to 4, wherein when a radius of the transverse cross-section of the wire is represented as r (mm) or a thickness of the wire is represented as t (mm), a region of 0.7r or 0.7t toward the outermost surface of the wire from the center O of the transverse cross-section is designated as a center portion, and a region to the outermost surface of the wire outside the center portion is designated as an outer circumferential portion, an area ratio Io(100) of grains having <100> orientation in the outer circumferential portion to the entire measurement area and an area ratio Ii(100) of grains having <100> orientation in the center portion to the entire measurement area satisfy the relationship represented by Io(100)/Ii(100) > 1.2.

6. The copper alloy wire according to any one of claims 1 to 4, wherein when a radius of the transverse cross-section of the wire is represented as r (mm) or a thickness of the wire is represented as t (mm), a region of 0.7r or 0.7t toward the outermost surface of the wire from the center O of the transverse cross-section is designated as a center portion, and a region to the outermost surface of the wire outside the center portion is designated as an outer circumferential portion, an area ratio Io(100) of grains having <100> orientation in the outer circumferential portion to the entire measurement area and an area ratio Ii(100) of grains having <100> orientation in the center portion to the entire measurement area satisfy the relationship represented by Io(100)/Ii(100) < 0.8.

7. The copper alloy wire according to any one of claims 1 to 6, wherein the area ratio of grains having <100> orientation is 55% or more of the entire measurement area and the area ratio of grains having <111> orientation is 25% or less of the entire measurement area.

**Patentansprüche**

1. Kupferlegierungsdraht, bestehend aus mindestens einem Bestandteil, ausgewählt aus der Gruppe bestehend aus:

   [1] 0,1 bis 4 Masse-% Ag; und
   [2] mindestens ein Element ausgewählt aus der Gruppe bestehend aus Sn, Mg, Zn, In, Ni, Co, Zr und Cr jeweils in einem Anteil von 0,05 bis 0,3 Masse-%,

   wobei der Rest Cu und unvermeidbare Verunreinigungen ist,
   wobei der Kupferlegierungsdraht eine rekristallisierte Textur aufweist, ein Flächenverhältnis der Körner mit einer <100> Orientierung von 30% oder mehr der gesamten Messfläche, wobei das Flächenverhältnis der Körner mit einer <100> Orientierung durch ein EBSD-Verfahren in einer solchen Weise erhalten wird, dass der transversale Querschnitt einer Kupferlegierungsdrahtprobe geglättet wird, um eine Messoberfläche zu bilden, wobei die Orientierung der Körner auf der Messoberfläche in einem Schritt von 0,02 $\mu$m in der gesamten Durchmesserrichtung der Kupferlegierungsdrahtprobe gemessen wird, nachdem die Messbedingungen in Bezug auf die Kupferlegierungsdrahtprobe so eingestellt sind, dass ein Vakuumgrad auf etwa $10^{-4}$ bis $10^{-5}$ Pa eingestellt ist, und eine Beschleunigungsspannung auf 20 bis 30 V eingestellt wird, und ein Zuverlässigkeitsindex, das heißt ein CI-Wert, wie mit der OIM-Software berechnet, auf 0,2 oder mehr eingestellt wird, und das Flächenverhältnis des Korns mit einer <100> Orientierung bezogen auf das gesamte Messgebiet basierend auf dem Messergebnis berechnet wird; und worin der Kupferlegierungsdraht eine Zugfestigkeit von 350 MPa oder mehr, einen halb-erweichten Zustand mit einer Dehnung von 10% bis 30% und einen Drahtdurchmesser oder eine Drahtdicke von 0,1 mm oder weniger und 0,01 mm oder mehr aufweist.

2. Kupferlegierungsdraht nach Anspruch 1, wobei das Flächenverhältnis der Körner mit einer <100> Orientierung 50% oder mehr der gesamten Messfläche beträgt.

3. Kupferlegierungsdraht nach Anspruch 1 oder 2, wobei das Flächenverhältnis der Körner mit einer <100> Orientierung weniger als 75% der gesamten Messfläche beträgt.

4. Kupferlegierungsdraht nach einem der Ansprüche 1 bis 3, wobei die durchschnittliche Korngröße der Matrix 0,2 $\mu$m oder mehr, jedoch 5 $\mu$m oder weniger beträgt.

**5.** Kupferlegierungsdraht nach einem der Ansprüche 1 bis 4, wobei, wenn ein Radius des transversalen Querschnitts des Drahtes als r (mm) dargestellt wird oder eine Dicke des Drahtes als t (mm) dargestellt wird, ein Bereich von 0,7r oder 0,7t zu der äußersten Oberfläche des Drahtes von der Mitte O des transversalen Querschnitts als ein mittlerer Bereich bezeichnet wird, und ein Bereich zu der äußersten Oberfläche des Drahts außerhalb des mittleren Bereichs als ein Außenumfangsabschnitt bezeichnet wird, ein Flächenverhältnis Io (100) von Körnern mit einer <100> Orientierung in dem Außenumfangsabschnitt zu der gesamten Messfläche und ein Flächenverhältnis Ii (100) von Körnern mit einer <100> Orientierung in dem mittleren Bereich zu der gesamten Messfläche die durch Io (100) / Ii (100) > 1,2 dargestellte Beziehung erfüllt.

**6.** Kupferlegierungsdraht nach einem der Ansprüche 1 bis 4, wobei, wenn ein Radius des transversalen Querschnitts des Drahtes als r (mm) dargestellt wird oder eine Dicke des Drahtes als t (mm) dargestellt wird, ein Bereich von 0,7r oder 0,7t zu der äußersten Oberfläche des Drahtes von der Mitte O des transversalen Querschnitts als ein mittlerer Bereich bezeichnet wird, und ein Bereich zu der äußersten Oberfläche des Drahts außerhalb des mittleren Bereichs als ein Außenumfangsabschnitt bezeichnet wird, ein Flächenverhältnis Io (100) von Körnern mit einer <100> Orientierung in dem Außenumfangsabschnitt zu der gesamten Messfläche und ein Flächenverhältnis Ii (100) von Körnern mit einer <100> Orientierung in dem mittleren Bereich zu der gesamten Messfläche die durch Io (100) / Ii (100) < 0,8 dargestellte Beziehung erfüllt.

**7.** Kupferlegierungsdraht nach einem der Ansprüche 1 bis 6, wobei das Flächenverhältnis von Körnern mit einer <100> Orientierung 55% oder mehr der gesamten Messfläche beträgt und das Flächenverhältnis von Körnern mit einer <111> Orientierung 25 % oder weniger der gesamten Messfläche beträgt.

**Revendications**

**1.** Un fil en alliage de cuivre constitué d'au moins un choisi dans le groupe comprenant:

[1] 0,1 à 4% en masse de Ag; et
[2] au moins un élément choisi dans le groupe constitué par Sn, Mg, Zn, In, Ni, Co, Zr et Cr, chacun à une teneur de 0,05 à 0,3% en masse,

le reste étant constitué de Cu et d'impuretés inévitables, le fil en alliage de cuivre ayant une texture recristallisée, un rapport de surface des grains ayant une orientation <100> égale ou supérieure à 30% de la région de mesure totale, dans lequel
le rapport de surface des grains ayant une orientation <100> est obtenu par un pro
cédé EBSD de telle sorte que la section transversale d'un échantillon de fil en alliage de cuivre soit lissée pour constituer une surface de mesure, l'orientation des grains sur la surface de mesure étant mesuré à un pas de 0,02 $\mu$m dans la direction du diamètre entier de l'échantillon de fil en alliage de cuivre après ajustement des conditions de mesure par rapport à l'échantillon de fil en alliage de cuivre de telle sorte qu'un degré de vide soit réglé sur environ $10^{-4}$ à $10^{-5}$ Pa, et une tension d'accélération est réglée sur 20 à 30 V, et un indice de fiabilité, c'est-à-dire une valeur de CI calculée par le logiciel OIM, est reglée sur 0,2 ou plus, puis le rapport de surface du grain ayant une orientation <100> par rapport à la zone de mesure totale est calculé sur la base du résultat de la mesure; et dans lequel
le fil en alliage de cuivre a une résistance à la traction de 350 MPa ou plus, un état semi-ramolli avec un allongement de 10% à 30% et un diamètre de fil ou une épaisseur de fil de 0,1 mm ou moins et de 0,01 mm ou plus.

**2.** Fil en alliage de cuivre selon la revendication 1, dans lequel le rapport de surface des grains ayant une orientation <100> est égal à 50% ou plus de la surface de mesure totale.

**3.** Fil en alliage de cuivre selon la revendication 1 ou 2, dans lequel le rapport de surface des grains ayant une orientation <100> est inférieur à 75% de la surface de mesure totale.

**4.** Fil en alliage de cuivre selon l'une quelconque des revendications 1 à 3, dans lequel la taille de grain moyenne de la matrice est de 0,2 $\mu$m ou plus mais de 5 $\mu$m ou moins.

**5.** Fil en alliage de cuivre selon l'une quelconque des revendications 1 à 4, dans lequel lorsqu'un rayon de la section transversale du fil est représenté par r (mm) ou une épaisseur du fil est représentée par t (mm), une région de 0,7r ou 0,7t vers la surface la plus externe du fil depuis le centre O de la section transversale est désignée par une partie centrale, et une région vers la surface la plus externe du fil à l'extérieur de la partie centrale est désignée par partie circonférentielle externe, un rapport de surface Io (100) de grains ayant une orientation <100> dans la partie circonférentielle externe par rapport à la zone de mesure entière et un rapport de surface Ii (100) de grains ayant une orientation <100> dans la partie centrale par rapport à la totalité de la zone de mesure satisfait la relation représentée par Io (100) / Ii (100) > 1.2.

6. Fil en alliage de cuivre selon l'une quelconque des revendications 1 à 4, dans lequel, lorsqu'un rayon de la section transversale du fil est représenté par r (mm) ou une épaisseur du fil est représentée par t (mm), une région de 0,7r ou 0,7t vers la surface la plus externe du fil depuis le centre O de la section transversale est désignée par une partie centrale, et une région vers la surface la plus externe du fil à l'extérieur de la partie centrale est désignée par partie circonférentielle externe, un rapport de surface Io (100) de grains ayant une orientation <100> dans la partie circonférentielle externe par rapport à la zone de mesure entière et un rapport de surface Ii (100) de grains ayant une orientation <100> dans la partie centrale par rapport à la totalité de la zone de mesure satisfait la relation représentée par Io (100) / Ii (100) <0,8.

7. Fil en alliage de cuivre selon l'une quelconque des revendications 1 à 6, dans lequel le rapport de surface des grains ayant une orientation <100> est égale ou supérieure à 55% de la surface de mesure totale et le rapport de surface des grains ayant une orientation <111> est de 25 % ou moins de toute la zone de mesure.

*Fig. 1*

(a)

Center portion        Outer circumferential portion

(b) Outer circumferential
        portion         Center portion

Outer circumferential portion

W

t   0.7t

## Fig. 2

Velocity: 100 cps
(1→3 Reciprocation: 1 time)

Sample

Dice

R = 1 (mm)

W = 2 0 g

**REFERENCES CITED IN THE DESCRIPTION**

**Patent documents cited in the description**

- JP 2009280860 A
- JP 3941304 B
- JP H04199277060 B
- CN 102851527 A